# EUROPEAN PATENT APPLICATION

(11) **EP 4 506 352 A1**
(43) Date of publication of application: **12.02.2025**
(21) Application number: 23773727.5
(22) Date of filing: 17.03.2023
(51) Int. Cl.: C07F 17/02, C09K 11/06, H01L 33/00

(54) **PLATINUM COMPLEX, ORGANIC PHOTOELECTRIC DEVICE, AND DISPLAY OR LIGHTING DEVICE**

(30) Priority: 22.03.2022 CN 202210286753
(71) Applicant: Zhejiang University of Technology, Hangzhou, Zhejiang 310014 (CN); Zhejiang Huaxian Photoelectricity Technology Co., Ltd, Jiaxing, Zhejiang 314107 (CN)
(72) Inventor: LI, Guijie, Hangzhou, Zhejiang 310014 (CN); SHE, Yuanbin, Hangzhou, Zhejiang 310014 (CN); ZHAN, Feng, Hangzhou, Zhejiang 310014 (CN); ZHAO, Xiaoyu, Jiaxing, Zhejiang 314107 (CN)
(74) Representative: Chung, Hoi Kan
(86) International application number: PCT/CN2023/082146
(87) International publication number: WO 2023/179479

(57) **Abstract**

The present invention provides a metal platinum complex, an organic optoelectronic device, and a display or lighting apparatus. A new 6/5/7 metal fused-ring structure is developed by using 8-phenylquinoline structure and a derivative thereof, and benzo five-membered heterocycles and a phenoxy oxygen tetradentate ligand, to obtain a new class of tetradentate cyclometalated platinum complex phosphor material. A chemical formula of the phosphor material is shown as the general formula (1):

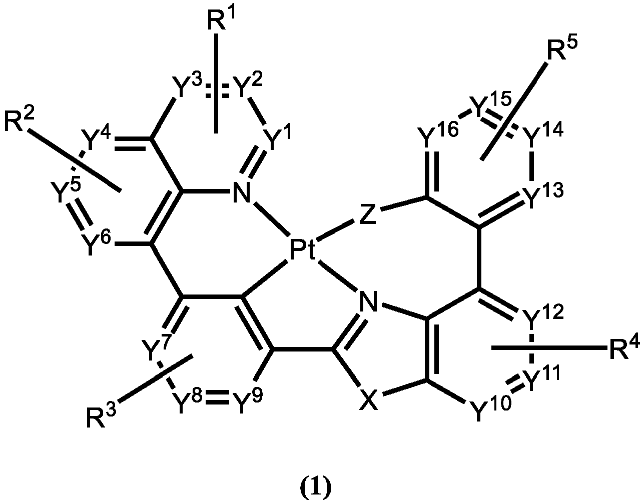

## Description

### TECHNICAL FIELD

The present invention relates to a metal platinum complex, and in particular to a metal platinum complex, an organic optoelectronic device, and a display or lighting apparatus.

### BACKGROUND

An organic light-emitting diode (OLED) has achieved rapid development in recent years. Compared with a liquid crystal display (LCD) display technology, the OLED has the following advantages: autonomous light emission without a back light source, and with energy conservation, capability of folding or curving, a fast response speed, a high contrast, a wide operating temperature range, a low cost and high light-emitting efficiency of a material, etc. The OLED has become a new generation of full-color display and lighting technology, which has received extensive attention from academia and industry. It has been widely used in flat panel display, solid state lighting, military and aerospace fields, and is expected to replace a liquid crystal display (LCD) in the future.

In the early stage of OLED development, a traditional fluorescent material is mainly used, having good device stability. However, in theory, a fluorescent material can only use up to 25% of singlet excitons, and the remaining 75% of triplet excitons can only be inactivated by a non-radiative transition due to transition forbidding, which limits application of the fluorescent material in the OLED. Due to the effect of spin-orbit coupling (SOC) of heavy metals, a cyclometalated platinum complex phosphor material can break the triplet transition forbidding, and effectively promotes the intersystem crossing of electrons from the singlet state to a triplet state, which makes full use of all the singlet and triplet excitons generated by electroexcitation, thereby enabling maximum theoretical quantum efficiency to reach 100%. In general, a ligand of the cyclometalated platinum complex phosphor material includes a luminophore and an auxiliary group. A change on the chemical structure of the ligand will affect an electronic structure of a complex, which in turn affects photophysical properties of the complex. Compared with bidentate and tridentate structures, a tetradentate cyclometalated structure can effectively reduce vibration coupling, and suppress non-radiative attenuation, which is conductive to improving a radiation rate, to achieve phosphorescence emission with high quantum efficiency. Although the current tetradentate cyclometalated platinum complex phosphor material has made a great progress, so far, a stable and efficient platinum complex phosphor material is still extremely limited. Therefore, development of a novel tetradentate cyclometalated structure platinum complex is still of great significance to development of the OLED industry.

### SUMMARY

In order to develop more types of phosphor materials with higher properties, a purpose of the present invention is to provide a tetradentate cyclometalated platinum complex phosphor material based on an 8-phenylquinoline derivative and an organic light-emitting device.

The tetradentate cyclometalated platinum complex phosphor material provided by the present invention includes a compound shown as the following general formula (1): 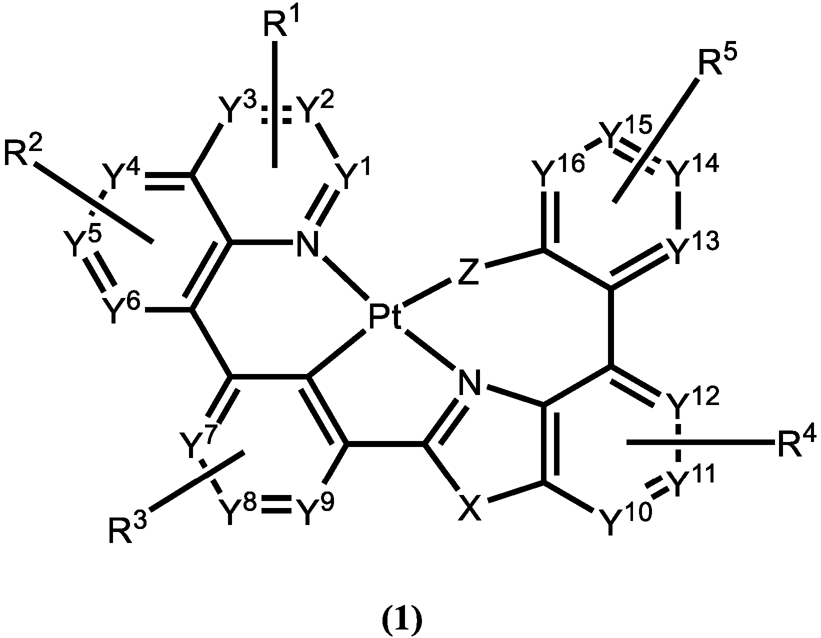 wherein
Y¹, Y², Y³, Y⁴, Y⁵, Y⁶, Y⁷, Y⁸, Y⁹, Y¹⁰, Y¹¹, Y¹², Y¹³, Y¹⁴, Y¹⁵ and Y¹⁶ are each independently CH or N;
R¹, R², R³, R⁴ and R⁵ each independently represent mono-substitution, di-substitution, tri-substitution, tetra-substitution or non-substitution, and are each independently hydrogen, deuterium, an aryl group, a cycloalkyl group, a cycloalkenyl group, a heterocyclic group, a heteroaryl group, an alkyl group, an alkenyl group, an alkynyl group, halogen, a hydroxyl group, a sulfhydryl group, a nitro group, a cyano group, an amino group, a mono- or di-alkylamino group, a mono- or di-arylamino group, an alkoxy group, an aryloxy group, a haloalkyl group, an ester group, a nitrile group, an isonitrile group, a heteroaryl group, an alkoxycarbonyl group, an amido group, an alkoxycarbonylamino group, an aryloxycarbonylamino group, a sulfonylamino group, a sulfamoyl group, a carbamoyl group, an alkylthio group, a sulfinyl group, a ureido group, a phosphoramide group, an imino group, a sulfo group, a carboxyl group, a hydrazino group, a substituted silyl group, a polymerized groups, or a combination thereof; and two or more adjacent R¹, R², R³, R⁴ and R⁵ are each linked independently or selectively to form a fused ring.

X represents NR^{a}, O, and S, wherein R^{a} represents the hydrogen, the deuterium, the aryl group, the cycloalkyl group, the cycloalkenyl group, the heterocyclic group, the heteroaryl group, the alkyl group, the alkenyl group, the alkynyl group, the halogen, the hydroxyl group, the sulfhydryl group, the alkoxy group, the aryloxy group, the haloalkyl group, the ester group, the nitrile group, the isonitrile group, the heteroaryl group, the alkoxycarbonyl group, the amido group, the alkoxycarbonylamino group, the aryloxycarbonylamino group, the sulfonylamino group, the sulfamoyl group, the carbamoyl group, the alkylthio group, the sulfinyl group, the ureido group, the phosphoramide group, the imino group, the sulfo group, the carboxyl group, the hydrazino group, the substituted silyl group, the polymerized groups, or a combination thereof; and it may be linked to adjacent R³ and R⁴ each independently or selectively to form a fused ring.

Z represents O, S, and NR^{b}, wherein R^{b} represents the hydrogen, the deuterium, the aryl group, the cycloalkyl group, the cycloalkenyl group, the heterocyclic group, the heteroaryl group, the alkyl group, the alkenyl group, the alkynyl group, the halogen, the hydroxyl group, the sulfhydryl group, the alkoxy group, the aryloxy group, the haloalkyl group, the ester group, the nitrile group, the isonitrile group, the heteroaryl group, the alkoxycarbonyl group, the amido group, the alkoxycarbonylamino group, the aryloxycarbonylamino group, the sulfonylamino group, the sulfamoyl group, the carbamoyl group, the alkylthio group, the sulfinyl group, the ureido group, the phosphoramide group, the imino group, the sulfo group, the carboxyl group, the hydrazino group, the substituted silyl group, the polymerized groups, or a combination thereof; and it may be linked to adjacent R¹ and R⁵ each independently or selectively to form a fused ring

Preferably, the structural formula of the phosphor material is arbitrary one of the following structural formulas:

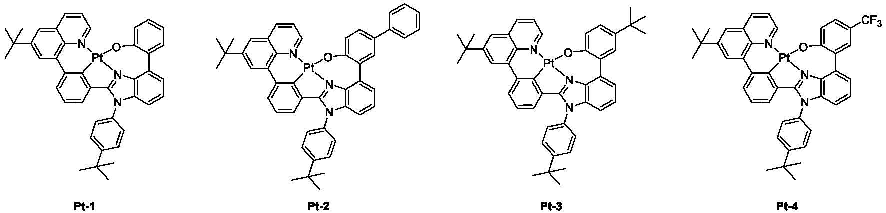

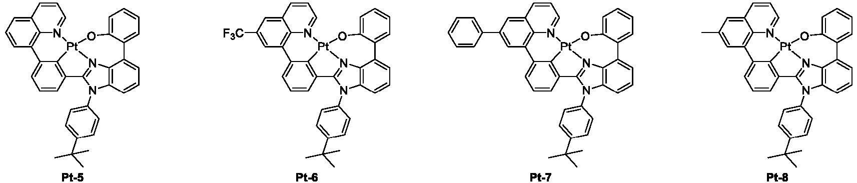

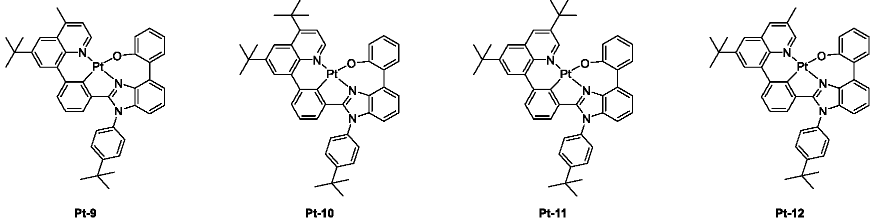

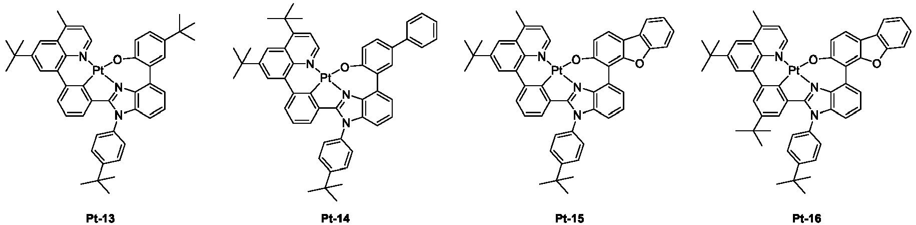

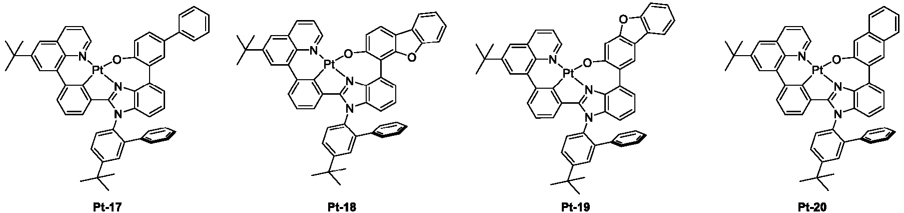

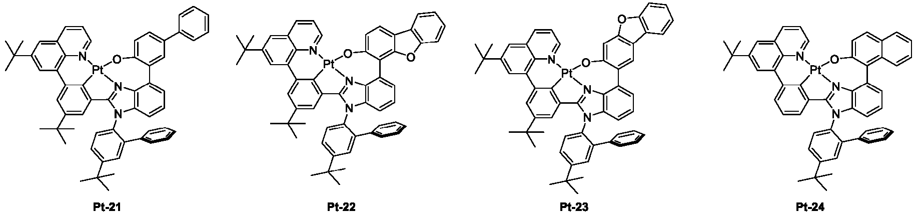

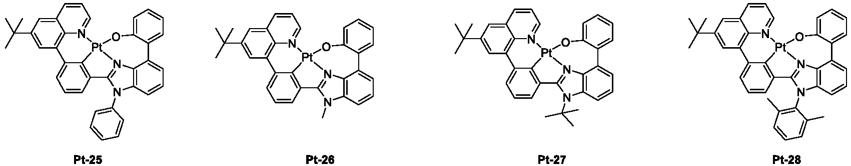

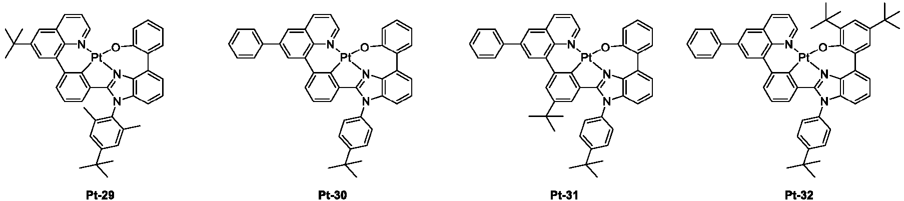

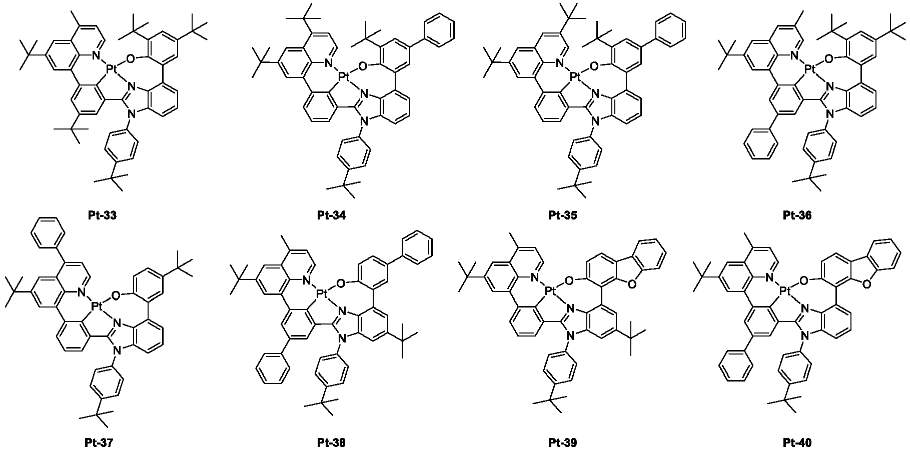

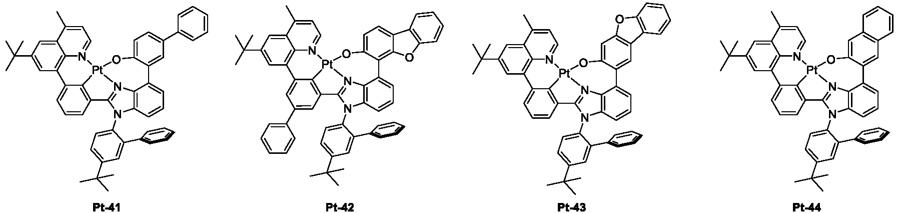

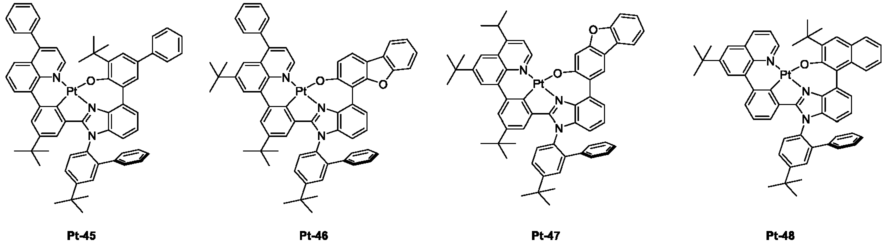

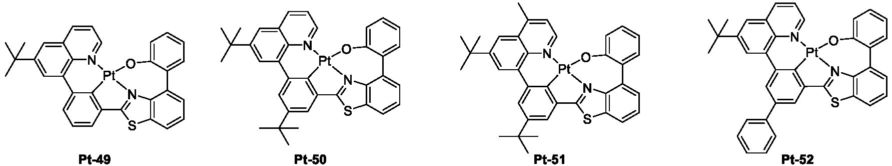

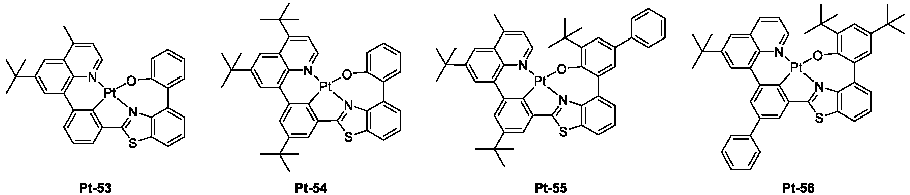

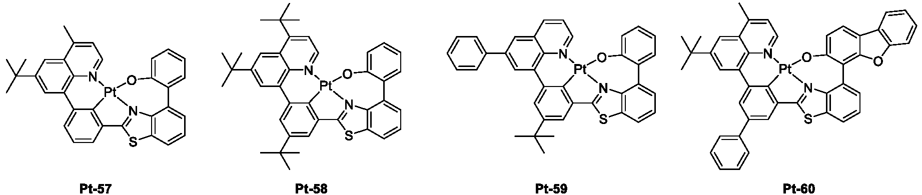

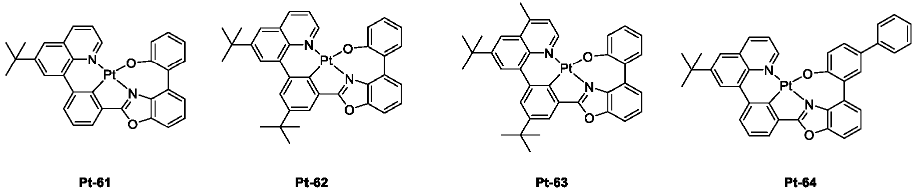

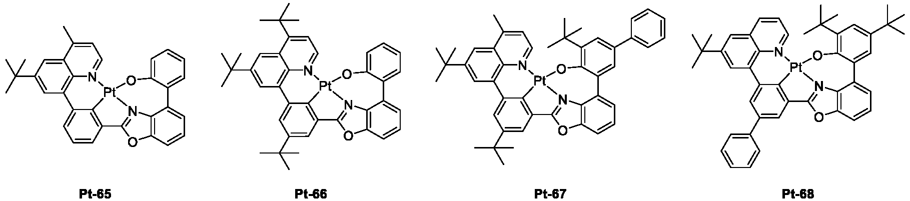

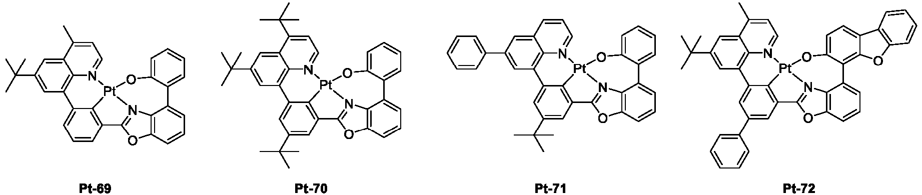

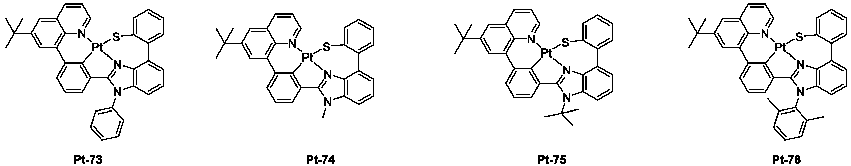

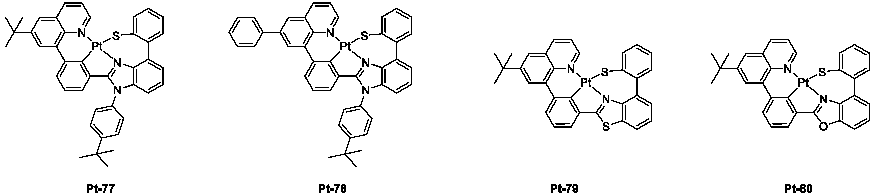

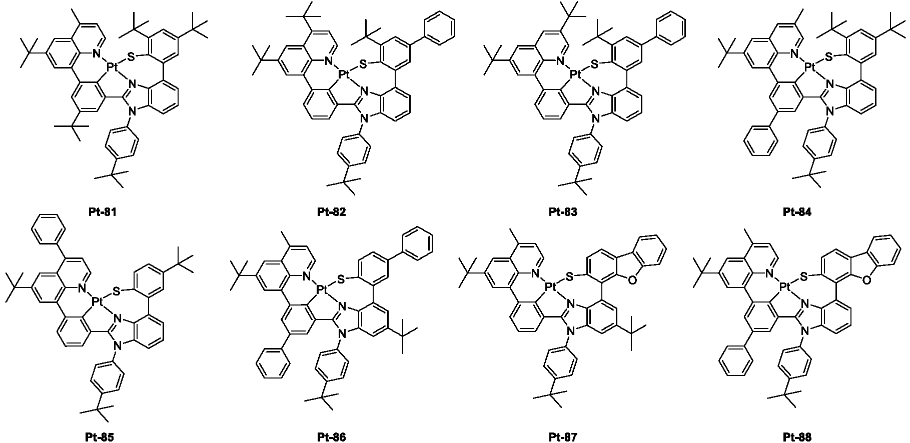

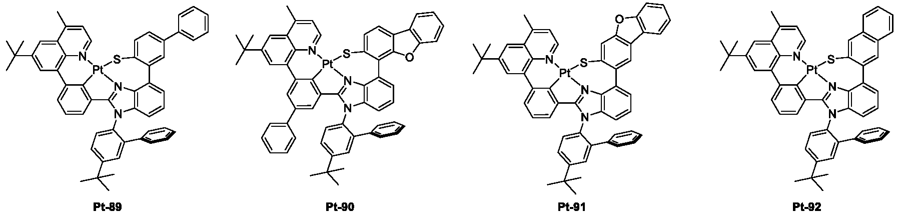

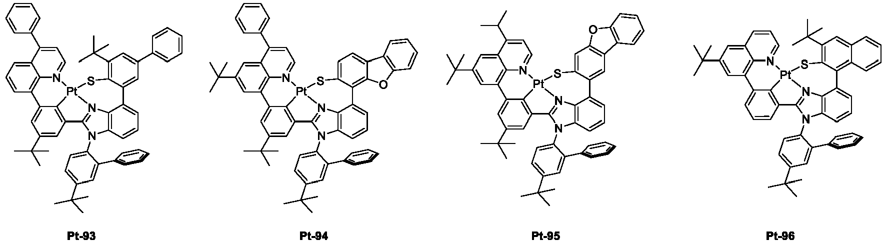

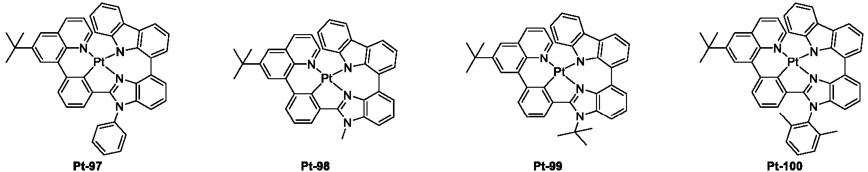

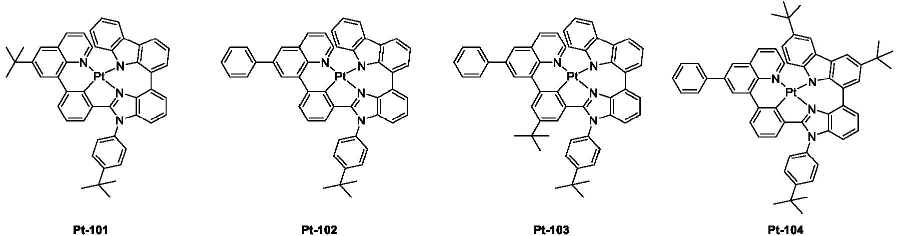

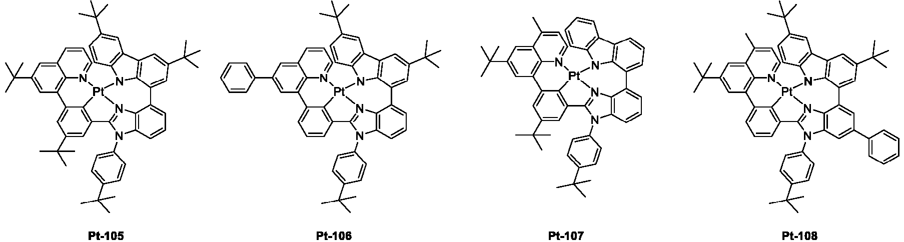

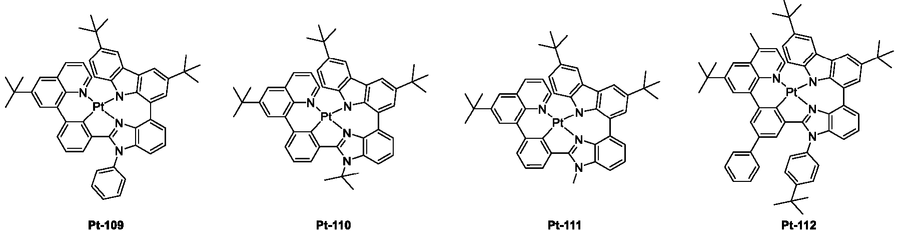

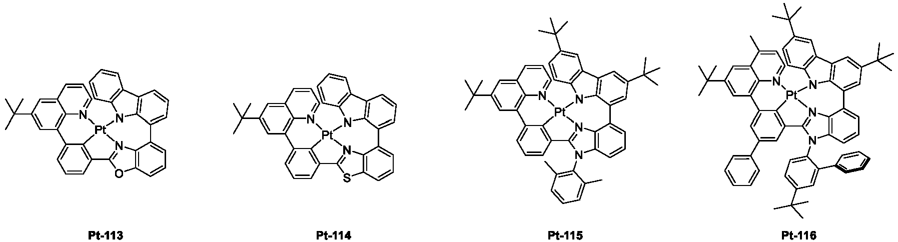

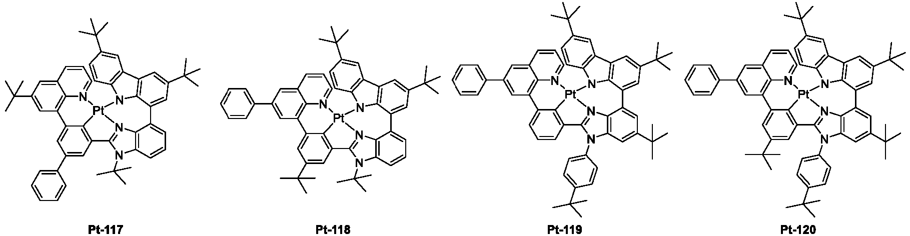

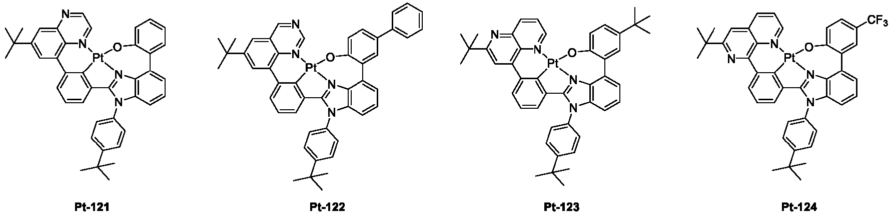

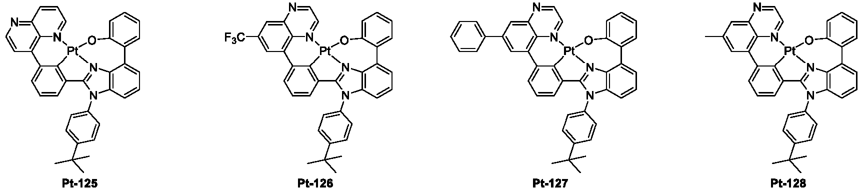

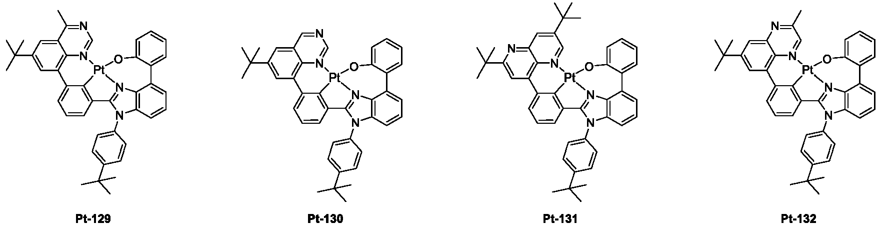

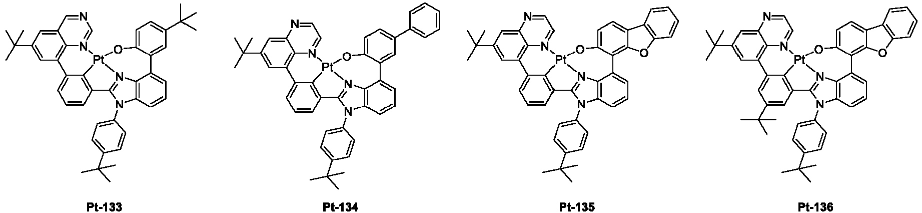

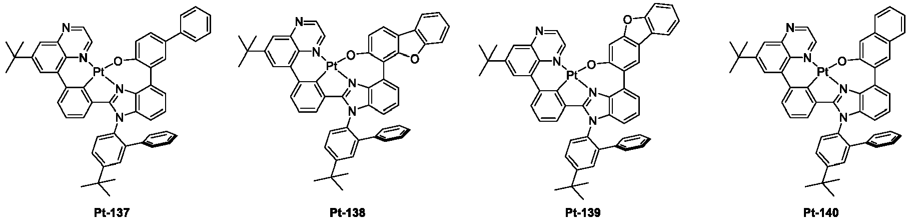

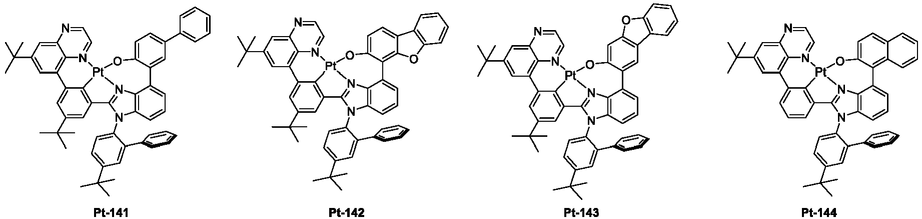

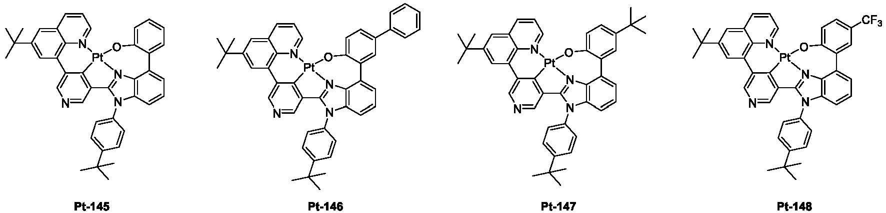

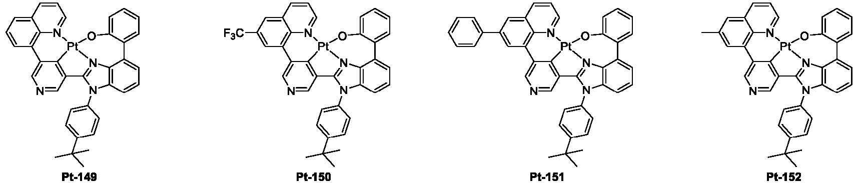

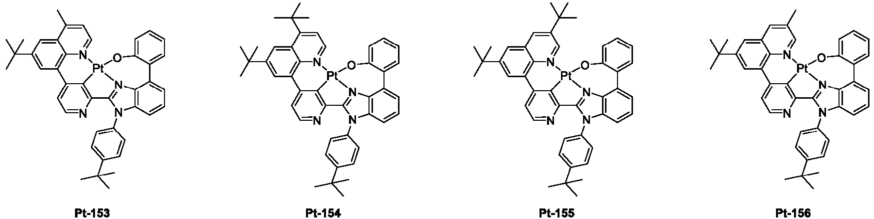

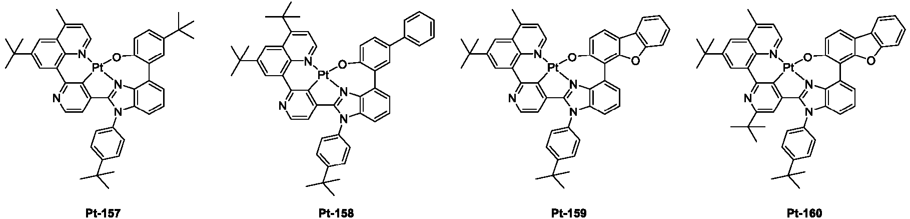

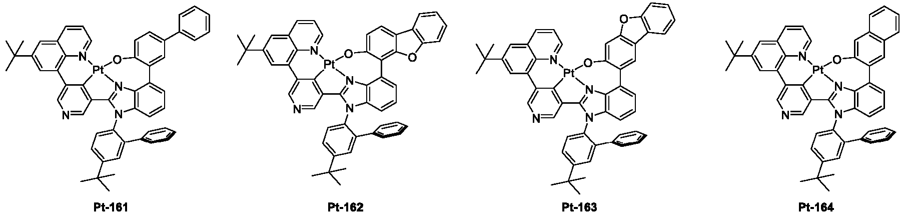

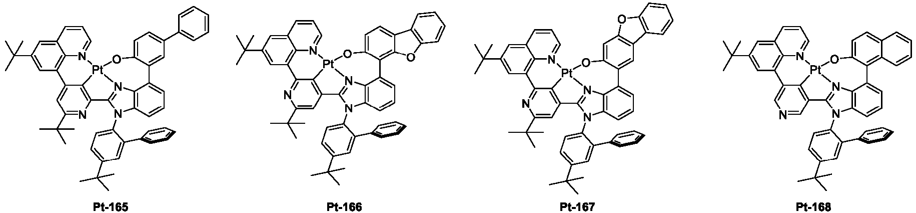

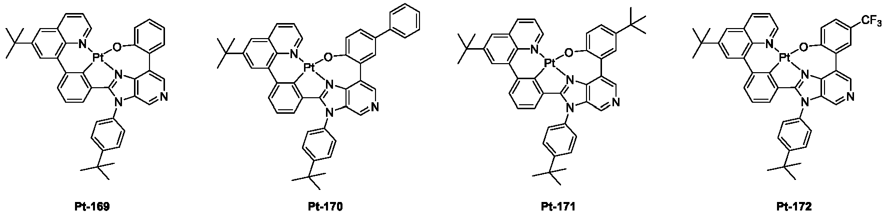

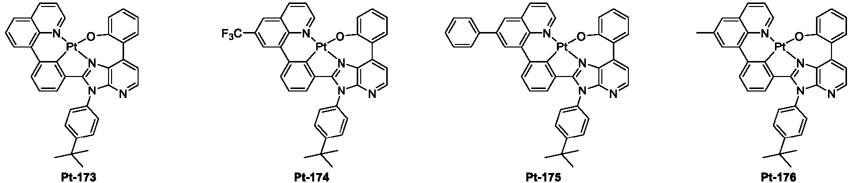

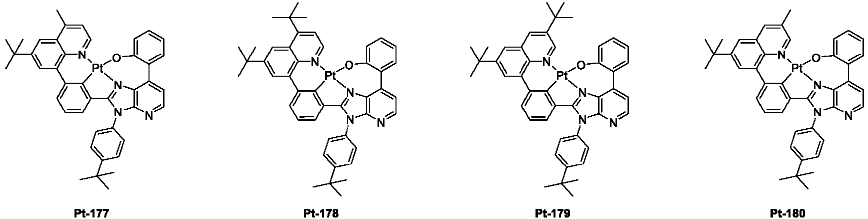

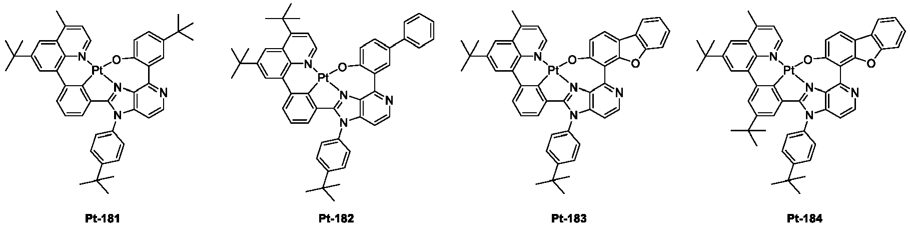

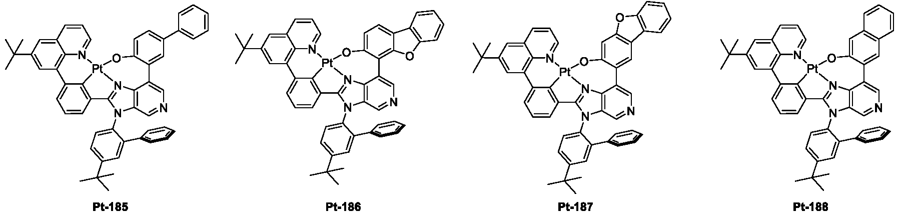

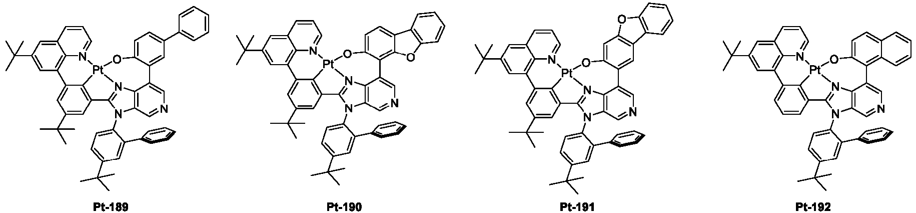

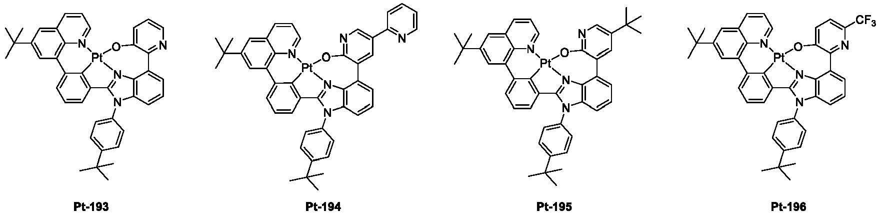

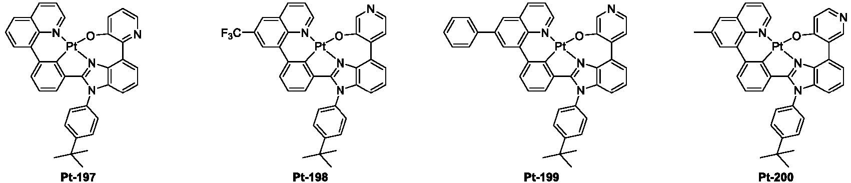

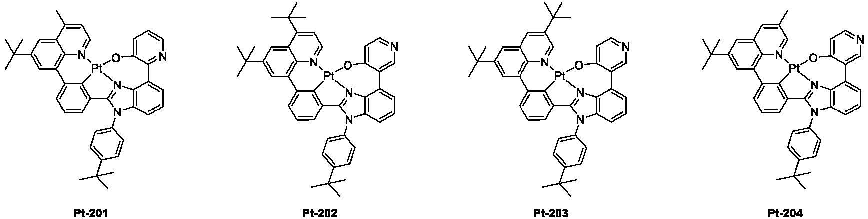

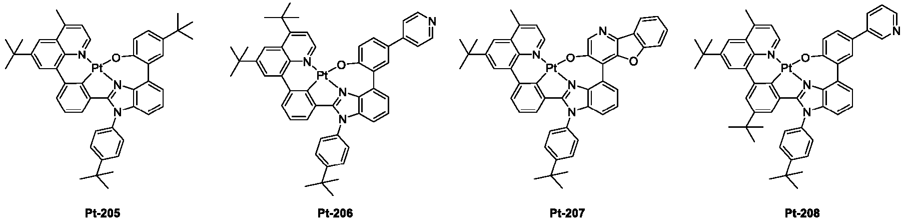

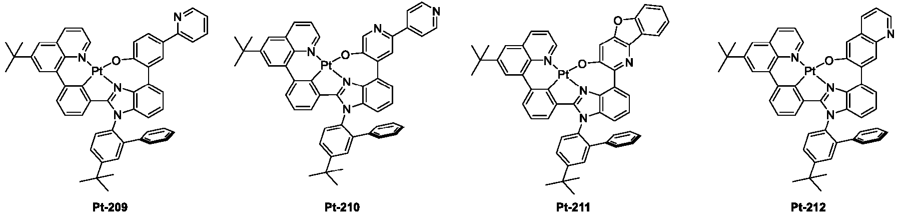

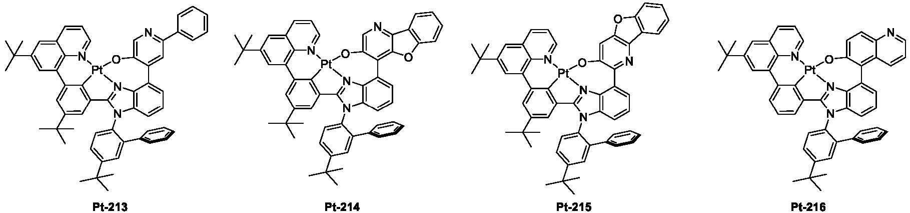

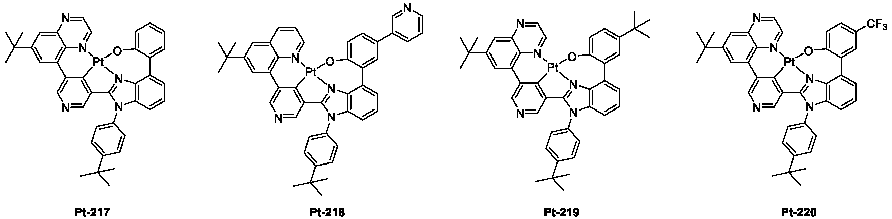

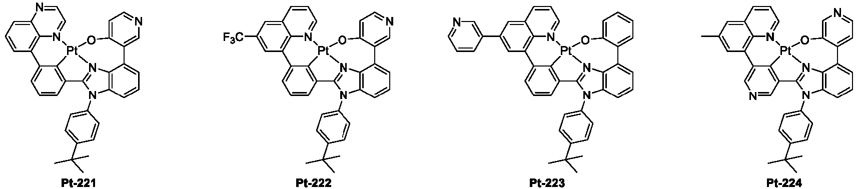

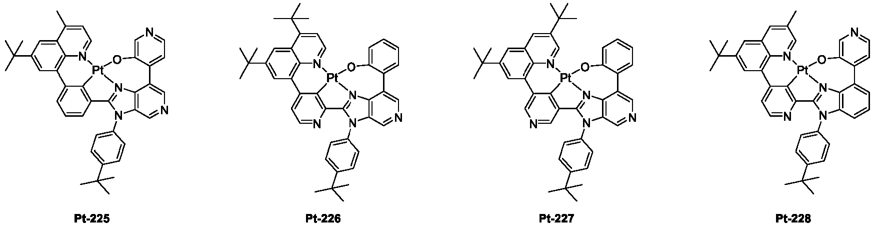

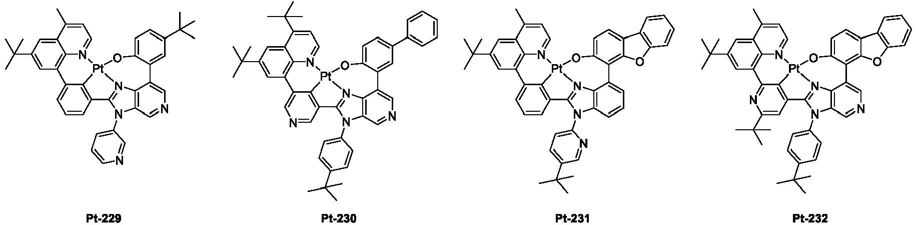

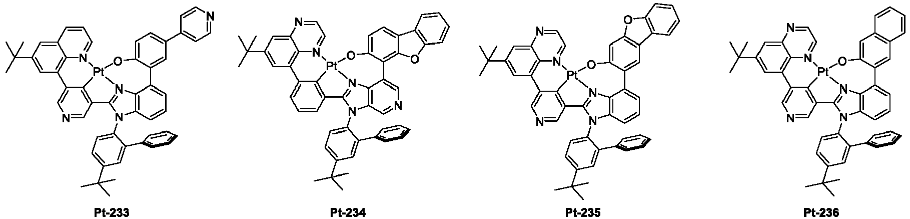

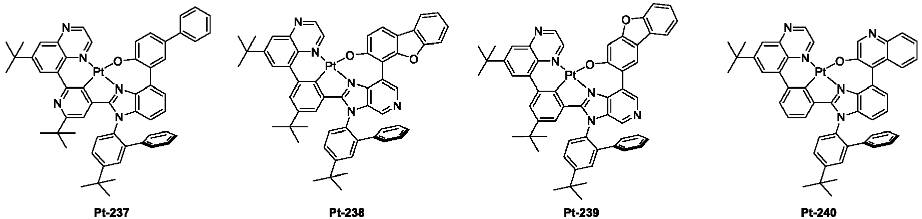

The present invention provides an organic optoelectronic device, including:
a first electrode;
a second electrode, facing the first electrode; and
an organic functional layer, sandwiched between the first electrode and the second electrode,
wherein the organic functional layer includes an organic metal complex of the present invention.

The present invention provides an organic optoelectronic device, including at least one of a cathode layer, an anode layer, and an organic layer. The organic layer includes a hole injection layer, a hole transporting layer, a light-emitting layer or an active layer, an electron injection layer, and an electron transporting layer, wherein arbitrary one layer of the device includes the organic metal complex of the present invention.

Preferably, the organic optoelectronic device is an organic photovoltaic device, an organic light-emitting device, an organic solar cell, electronic paper, an organic photoreceptor, an organic thin film transistor, or an organic memory device, preferably, an organic light-emitting diode device or a light-emitting electrochemical cell.

Preferably, the light-emitting layer includes the organic metal complex and a corresponding host material, wherein a mass percentage of the organic metal complex is 1%-50%.

The present invention further provides an organic light-emitting device, wherein a substrate is provided with a light-emitting layer including the metal platinum complex of the present invention.

The present invention further provides a device, including the metal platinum complex of the present invention.

Preferably, the device is a full-color display, a photovoltaic device, a light-emitting display device, or an organic light-emitting diode.

Preferably, the device includes at least one cathode, at least one anode, and at least one light-emitting layer; and at least one of the light-emitting layers includes the metal platinum complex of the present invention.

Preferably, the device is the organic light-emitting diode; and the light-emitting layer of the device includes the metal platinum complex and a corresponding host material, wherein a mass percentage of the metal platinum complex is 1-50%, and there is no limitation to the host material. The present invention further provides application of an organic metal complex in manufacturing an organic optoelectronic device.

The present invention further provides a display or lighting apparatus, including the organic optoelectronic device of the present invention.

Preferably, the present invention provides application of a tetradentate cyclometalated platinum complex phosphor material on an 8-phenylquinoline derivative in an organic light-emitting device. The organic light-emitting device is the organic light-emitting diode, the light-emitting diode or the light-emitting electrochemical cell.

Compared with the prior art, the present invention uses an 8-phenylquinoline structure and a derivative thereof, and benzo five-membered heterocycles and a phenoxy oxygen tetradentate ligand to develop a new 6/5/7 metal fused-ring structure, so as to obtain a new class of tetradentate cyclometalated platinum complex phosphor material.

### BRIEF DESCRIPTION OF DRAWINGS

FIG. 1 is an emission spectrum of a metal platinum (II) phosphorescent emitting material in a deoxygenized state in a dichloromethane solution at a room temperature in embodiment 1 of the present invention;
FIGs. 2a-b are schematic diagrams of distribution of HOMO and LUMO orbits of a compound Pt-1 respectively;
FIGs. 3a-b are schematic diagrams of distribution of HOMO and LUMO orbits of a compound Pt-77 respectively;
FIGs. 4a-b are schematic diagrams of distribution of HOMO and LUMO orbits of a compound Pt-49 respectively;

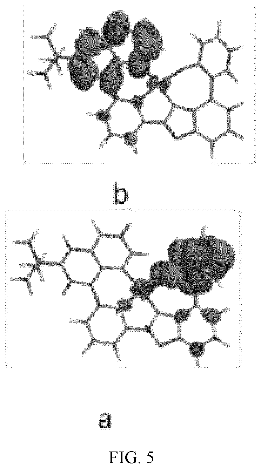

FIGs. 5a-b are schematic diagrams of distribution of HOMO and LUMO orbits of a compound Pt-61 respectively;

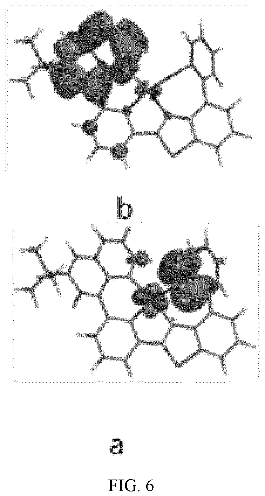

FIGs. 6a-b are schematic diagrams of distribution of HOMO and LUMO orbits of a compound Pt-79 respectively;

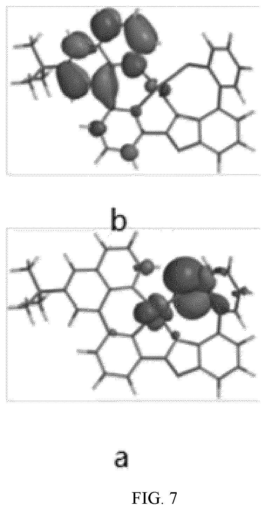

FIGs. 7a-b are schematic diagrams of distribution of HOMO and LUMO orbits of a compound Pt-80 respectively;

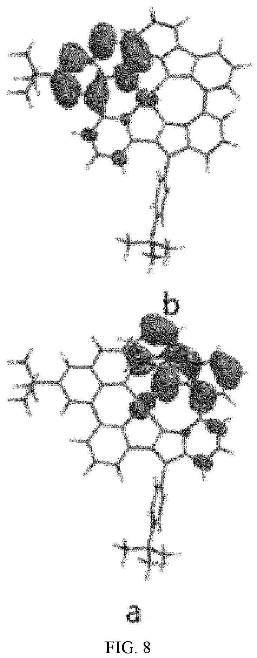

FIGs. 8a-b are schematic diagrams of distribution of HOMO and LUMO orbits of a compound Pt-101 respectively;

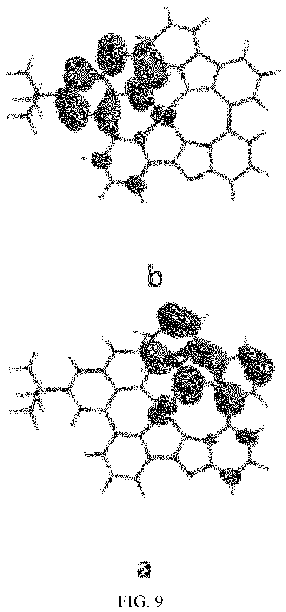

FIGs. 9a-b are schematic diagrams of distribution of HOMO and LUMO orbits of a compound Pt-113 respectively;

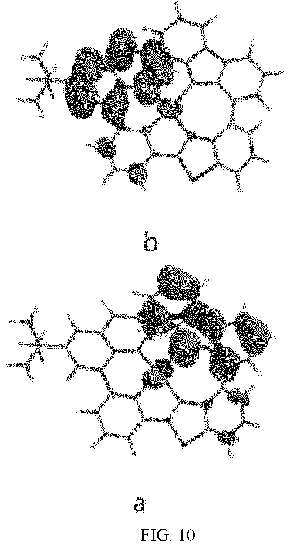

FIGs. 10a-b are schematic diagrams of distribution of HOMO and LUMO orbits of a compound Pt-114 respectively; and

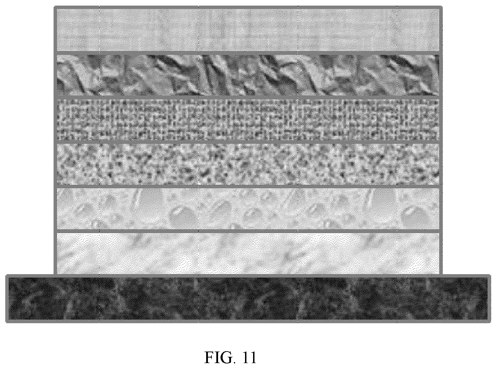

FIG. 11 is a schematic structural diagram of an organic light-emitting device of the present invention.

### DETAILED DESCRIPTION OF THE EMBODIMENTS

The present disclosure is more readily understood from with reference to the specific implementations and embodiments included therein. Prior to disclosing and describing the compounds, devices, and/or methods of the present invention, it should be understood that they are not limited to specific synthetic methods or specific reagents, unless otherwise stated. It because this can be varied. It should also be understood that the terms used in the present invention are only used for describing specific aspects, and are not intended to be limiting. Although any similar or equivalent methods and materials described in the present invention can be used in this practice or experiment, exemplary methods and materials are now described.

The singular forms "a", "an" and "the" of the terms used in the specification and the appended claims include plural referents, unless the context clearly dictates otherwise. Therefore, for example, reference to "components" includes a mixture of two or more components.

The term "optional" or "optionally" used in the present invention means that the event or situation subsequently described may or may not occur, and the description includes an example where the event or situation occurs and an example where it does not occur.

A component which may be used for preparing a composition of the present invention, and the composition itself to be used in a method disclosed in the present invention are disclosed. The present invention discloses these and other materials. It should be understood that the present invention discloses a combination, a subset, an interaction, a group, etc. of these substances. Although specific reference of various different individual and total combinations and arrangements of these compounds cannot be specifically disclosed, each has their own specific assumptions and descriptions. For example, if a specific compound is disclosed and discussed, and many modifications that can be made to many molecules including the compound are discussed, then each combination and arrangement of the compound and possible modifications are specifically considered, unless opposite possible modifications are specifically indicated. Therefore, if examples of a class of molecules A, B, and C, a class of molecules D, E, and F, and a combination of molecules A-D are disclosed, then even if each of them is not recorded separately, each individual and total meaning combination such as A-E, A-F, B-D, B-E, B-F, C-D, C-E, and C-F, is also considered to be disclosed. Similarly, any one of subsets or a combination of the subsets is also disclosed. For example, subgroups of A-E, B-F, and C-E are also disclosed. This concept is applicable to all aspects of the present invention, including, but not limited to, the steps in the method of preparing and using the composition. Therefore, if there are a variety of other steps that can be performed, it should be understood that these other steps can be performed by the specific implementation of the method or a combination of the implementations.

A glue atom used in the present invention can link two groups, for example, connect N and C. The glue atom can be optionally (if allowed by a valence bond) attached to other chemical groups. For example, an oxygen atom cannot have any other chemical group attached, because once two atoms (for example, N or C) are bonded, the valence bond is satisfied. On the contrary, when carbon is the glue atom, two another chemical groups can be attached to the carbon atom. Suitable chemical groups include, but are not limited to, hydrogen, a hydroxyl group, an alkyl group, an alkoxy group, = O, halogen, a nitro group, an amido group, an acylamino group, a sulfhydryl group, an aryl group, a heteroaryl group, a cycloalkyl group, and a heterocyclic group.

The term "cyclic structure" or a similar term used in the present invention refers to any cyclic chemical structure, including, but not limited to, the aryl group, the heteroaryl group, the cycloalkyl group, a cycloalkenyl group, the heterocyclic group, carbene, and N-heterocyclic carbene.

The term "substituted" or a similar term used in the present invention includes all allowed substituents of an organic compound. Broadly, the allowed substituents include cyclic and non-cyclic, branched and non-branched, carbocyclic and heterocyclic, aromatic and non-aromatic substituents of the organic compound. For example, exemplary substituents include the following substituents. For a suitable organic compound, there may be one or more allowed substituents, same or different. For the purpose of the present invention, a heteroatom (for example, nitrogen) can have a hydrogen substituent and/or any allowed substituent, satisfying a valence bond of the heteroatom, of the organic compound of the present invention. The present invention is not intended in any way to impose any limitation to the substituents allowed by the organic compound. Similarly, the term "substituted" or "substituted with" includes the implicit proviso that such substitution is in accordance with the allowed valence bond of the substituted atom and the substituent, and that the substitution results in a stable compound (e.g., the compound which does not spontaneously undergo transformation (such as by rearrangement, cyclization, elimination, etc.)). In some respects, individual substituents can be further optionally substituted (i.e., further substituted or unsubstituted), unless clearly indicated to the contrary.

In defining various terms, "R¹", "R²", "R³" and "R⁴" are used in the present invention as generic symbols to represent various specific substituents. These symbols can be any substituent, not limited to those disclosed in the present invention. When they are defined as certain substituents in one example, they can also be defined as some other substituents in another example.

The term "alkyl group" used in the present invention is a branched or non-branched saturated hydrocarbyl group of 1 to 30 carbon atoms, for example, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a neopentyl group, a hexyl group, a heptyl group, an octyl group, a nonyl group, a decyl group, a dodecyl group, a tetradecyl group, a hexadecyl group, an icosyl group, a tetracosyl group, etc. The alkyl group may be cyclic or non-cyclic. The alkyl group may be branched or non-branched. The alkyl group may also be substituted or unsubstituted. For example, the alkyl group may be substituted with one or more groups, including, but not limited to, optionally substituted alkyl group, cycloalkyl group, alkoxy group, amino group, ether, halogen, hydroxyl group, nitro group, silyl group, thio-oxo group, and sulfhydryl group described in the present invention. A "lower alkyl" group is an alkyl group including 1 to 6 (for example, 1 to 4) carbon atoms.

Throughout the specification, the "alkyl group" usually refers to both the unsubstituted alkyl group and the substituted alkyl group; however, the substituted alkyl group is also specifically mentioned in the present invention by identifying a specific substituent on the alkyl group. For example, the term "halogenated alkyl group" or "haloalkyl group" specifically refers to the alkyl group that is substituted with one or more halogens (for example, fluorine, chlorine, bromine, or iodine). The term "alkoxyalkyl group" specifically refers to the alkyl group substituted with one or more alkoxy groups, as described below. The term "alkoxyalkyl group" specifically refers to the alkyl group substituted with one or more alkylamino groups, as described below like. When the "alkyl group" is used in one instance and a specific term such as "alkylalcohol" is used in another instance, it is not meant to imply that the term "alkyl group" does not also refer to the specific term such as "alkylalcohol".

This method is also used for other groups of the present invention. That is, when the term such as "cycloalkyl group" refers to both the unsubstituted and substituted cycloalkyl moieties, the substituted moieties may be specified separately in the present invention; for example, the specific substituted cycloalkyl group may be called, for example, "alkylcycloalkyl group". Likewise, the substituted alkoxy group may be specifically called, for example, "haloalkoxy group", and the specific substituted alkenyl group may be for example, "enol", etc. Similarly, the use of the generic term such as "cycloalkyl group" and the specific term such as "alkylcycloalkyl group" does not mean that the generic term does not also include the specific term.

The term "cycloalkyl group" used in the present invention is a non-aromatic carbon-based ring of 3 to 30 carbon atoms, which is composed of at least three carbon atoms. Examples of the cycloalkyl group includes, but is not limited to, a cyclopropyl group, a cyclobutyl group, a cyclopentyl group, a cyclohexyl group, a cyclononyl group, etc. The term "heterocycloalkyl group" is a class of cycloalkyl groups as defined above, and is included in the meaning of the term "cycloalkyl group", wherein at least one ring carbon atom is substituted by the heteroatom such as, but not limited to, nitrogen, oxygen, sulfur or phosphorus. The cycloalkyl group and the heterocycloalkyl group may be substituted or unsubstituted. The cycloalkyl group and the heterocycloalkyl group may be substituted with one or more groups, including, but not limited to, the alkyl group, the cycloalkyl group, the alkoxy group, the amino group, the ether, the halogen, the hydroxyl group, the nitro group, the silyl group, the thio-oxo group, and the sulfhydryl group described in the present invention.

The term "polyolefin group" used in the present invention refers to a group including two or more CH₂ groups linked to each other. The "polyolefin group" may be expressed as - (CH₂)ₐ-, wherein "a" is an integer between 2 and 500.

The terms "alkoxy" and "alkoxy group" used in the present invention refer to the alkyl or cycloalkyl group of 1 to 30 carbon atoms bonded by an ether bond, that is, the "alkoxy group" can be defined as -OR¹, wherein R¹ is the alkyl or cycloalkyl group as defined above. The "alkoxy group" also includes an alkoxy polymer just described, that is, the alkoxy group may be polyether, such as -OR¹-OR² or -OR¹-(OR²)ₐ-OR³, wherein "a" is an integer from 1 to 500, while R¹, R²and R³ are each independently the alkyl group, the cycloalkyl group, or a combination thereof.

The term "alkenyl group" used in the present invention is a hydrocarbyl group having 2 to 30 carbon atoms; and the structural formula of the hydrocarbyl group includes at least one carbon-carbon double bond. An unsymmetric structure such as (R1R2)C=C(R3R4) includes E and Z isomers. It can be presumed there is unsymmetrical alkene in the structural formula of the present invention, or the unsymmetrical alkene may be clearly indicated by a bond symbol C=C. The alkenyl group may be substituted with one or more groups, including, but not limited to, the alkyl group, the cycloalkyl group, the alkoxy group, the alkenyl group, the cycloalkenyl group, the alkynyl group, the cycloalkynyl group, the aryl group, the heteroaryl group, aldehyde, the amino group, carboxylic acid, ester, the ether, the halogen, the hydroxyl group, ketone, azido group, the nitro group, the silyl group, the thio-oxo group, or the sulfhydryl group described in the present invention.

The term "cycloalkenyl group" used in the present invention is a non-aromatic carbon-based ring of 3 to 30 carbon atoms, which is composed of at least three carbon atoms, and includes at least one carbon-carbon double bond, i.e. C=C. An example of the cycloalkenyl group includes, but is not limited to, a cyclopropyl group, a cyclobutyl group, a cyclopentenyl group, a cyclopentadienyl group, a cyclohexenyl group, a cyclohexadienyl group, a cycloheptenyl group, etc. The term "heterocyclicalkenyl group" is a class of cycloalkenyl groups as defined above, and is included in the meaning of the term "cycloalkenyl group", wherein at least one carbon atom of this ring is substituted by the heteroatom such as, but not limited to, the nitrogen, the oxygen, the sulfur or the phosphorus. The cycloalkenyl group and the heterocyclicalkenyl group may be substituted or unsubstituted. The cycloalkenyl group and the heterocyclicalkenyl group may be substituted with one or more groups, including, but not limited to, the alkyl group, the cycloalkyl group, the alkoxy group, the alkenyl group, the cycloalkenyl group, the alkynyl group, the cycloalkynyl group, the aryl group, the heteroaryl group, the aldehyde, the amino group, the carboxylic acid, the ester, the ether, the halogen, the hydroxyl group, the ketone, the azido group, the nitro group, the silyl group, the thio-oxo group, or the sulfhydryl group described in the present invention.

The term "alkynyl group" used in the present invention is a hydrocarbyl group having 2 to 30 carbon atoms; and the structural formula of the hydrocarbyl group includes at least one carbon-carbon triple bond. The alkynyl group may be substituted with one or more groups, including, but not limited to, the alkyl group, the cycloalkyl group, the alkoxy group, the alkenyl group, the cycloalkenyl group, the alkynyl group, the cycloalkynyl group, the aryl group, the heteroaryl group, the aldehyde, the amino group, the carboxylic acid, the ester, the ether, the halogen, the hydroxyl group, the ketone, the azido group, the nitro group, the silyl group, the thio-oxo group, or the sulfhydryl group described in the present invention.

The term "cycloalkynyl group" used in the present invention is a non-aromatic carbon-based ring, including at least 7 carbon atoms and at least one carbon-carbon triple bond. An example of the cycloalkynyl group includes, but is not limited to, a cycloheptynyl group, a cyclooctynyl group, a cyclononynyl group, etc. The term "heterocyclylalkynyl group" is a class of cycloalkynyl groups as defined above, and is included in the meaning of the term "cycloalkynyl group", wherein at least one of carbon atoms of this ring is substituted by the heteroatom, for example, but not limited to, the nitrogen, the oxygen, the sulfur or the phosphorus. The cycloalkynyl group and the heterocyclylalkynyl group may be substituted or unsubstituted. The cycloalkynyl group and the heterocyclylalkynyl group may be substituted with one or more groups, including, but not limited to, the alkyl group, the cycloalkyl group, the alkoxy group, the alkenyl group, the cycloalkenyl group, the alkynyl group, the cycloalkynyl group, the aryl group, the heteroaryl group, the aldehyde, the amino group, the carboxylic acid, the ester, the ether, the halogen, the hydroxyl group, the ketone, the azido group, the nitro group, the silyl group, the thio-oxo group, or the sulfhydryl group described in the present invention.

The term "aryl group" used in the present invention refers to any carbon-based aromatic group including 60 carbon atoms or less, including, but not limited to, benzene, naphthalene, a phenyl group, biphenyl, phenoxybenzene, etc. The term "aryl group" also includes "heteroaryl group", and is defined as a group including an aromatic group. A ring of the aromatic group includes at least one heteroatom. An example of the heteroatom includes, but is not limited, the nitrogen, the oxygen, the sulfur or the phosphorus. Similarly, the term "non-heteroaryl group" (also included in the "aryl group") defines a group including an aromatic group which does not include a heteroatom. The aryl group may also be substituted or unsubstituted. The aryl group may be substituted with one or more groups, including, but not limited to, the alkyl group, the cycloalkyl group, the alkoxy group, the alkenyl group, the cycloalkenyl group, the alkynyl group, the cycloalkynyl group, the aryl group, the heteroaryl group, the aldehyde, the amino group, the carboxylic acid, the ester, the ether, the halogen, the hydroxyl group, the ketone, the azido group, the nitro group, the silyl group, the thio-oxo group, or the sulfhydryl group described in the present invention. The term "biaryl group" is a specific type of aryl group, and is included in the definition of the "aryl group". The "biaryl group" refers to two aryl groups that are fused together by a fused ring structure, as in naphthalene, or two aryl groups that are linked by one or more carbon-carbon bonds, as in biphenyl.

The term "aldehyde" used in the present invention is expressed by the formula -C(O)H. Throughout the specification, "C(O)" is an abbreviation of the carbonyl (i.e., C=O).

The term "amine" or "amino group" used in the present invention is expressed by the formula -NR¹R², wherein R¹ and R² may be independently selected from the hydrogen, the alkyl group, the cycloalkyl group, the alkenyl group, the cycloalkenyl group, the alkynyl group, the cycloalkynyl group, the aryl group, or the heteroaryl group.

The term "alkoxyalkyl group" used in the present invention is expressed by the formula -NH(-alkyl), wherein the alkyl group is described in the present invention. Representative examples include, but are not limited to, a methylamino group, an ethylamino group, a propylamino group, an isopropyl amino group, a butylamino group, an isobutylamino group, a sec-butylamino group, a tert-butylamino group, a pentylamino group, an isopentylamino group, a tert-pentylamino group, a hexylamino group, etc.

The term "di-alkylamino group" used in the present invention is expressed by the formula -N(-alkyl)₂, wherein the alkyl group is described in the present invention. Representative examples include, but are not limited to, a dimethylamino group, a diethylamino group, a dipropylamino group, a diisopropylamino group, a dibutylamino group, a diisobutylamino group, a di-sec-butylamino group, a di-tert-butylamino group, a dipentylamino group, a diisopentylamino group, a di-tert-pentylamino group, a dihexylamino group, N-ethyl-N-methylamino, N-methyl-N-propylamino, N-ethyl-N-propylamino, etc.

The term "carboxylic acid" used in the present invention is expressed by the formula -C(O)OH.

The term "ester" used in the present invention is expressed by the formula - OC(O)R¹ or -C(O)OR¹, wherein R¹ may be the alkyl group, the cycloalkyl group, the alkenyl group, the cycloalkenyl group, the alkynyl group, the cycloalkynyl group, the aryl group, or the heteroaryl group described in the present invention. The term "polyester" used in the present invention is expressed by the formula -(R¹O(O)C-R²-C(O)O)ₐ- or -(R¹O(O)C-R²-OC(O))ₐ-, wherein R¹ and R² may independently be the alkyl group, the cycloalkyl group, the alkenyl group, the cycloalkenyl group, the alkynyl group, the cycloalkynyl group, the aryl group, or the heteroaryl group described in the present invention; and "a" is an integer from 1 to 500. The term "polyester" is used for describing a group produced by a reaction between a compound having at least two carboxyl groups and a compound having at least two hydroxyl groups.

The term "ether" used in the present invention is expressed by the formula R¹OR², wherein R¹ and R² may independently be the alkyl group, the cycloalkyl group, the alkenyl group, the cycloalkenyl group, the alkynyl group, the cycloalkynyl group, the aryl group, or the heteroaryl group described in the present invention. The term "polyether" used in the present invention is expressed by the formula -(R¹O-R²O)ₐ-, wherein R¹ and R² may independently be the alkyl group, the cycloalkyl group, the alkenyl group, the cycloalkenyl group, the alkynyl group, the cycloalkynyl group, the aryl group, or the heteroaryl group described in the present invention; and "a" is an integer from 1 to 500. An example of a polyether group includes polyethylene oxide, polypropylene oxide, and polyoxybutylene.

The term "halogen" used in the present invention refers to fluorine, chlorine, bromine and iodine as halogens.

The term "heterocyclic group" used in the present invention refers to non-aromatic monocyclic and polycyclic systems, and the term "heteroaryl group" used in the present invention refers to aromatic monocyclic and polycyclic systems with no more than 60 carbon atoms: wherein at least one of ring members is not carbon. The term includes an azetidinyl group, a dioxanyl group, a furyl group, an imidazolyl group, an isothiazolyl group, an isooxazolyl group, a morpholinyl group, an oxazolyl group (including 1,2,3-oxazolyl, 1,2,5-oxazolyl, and 1,3,4-oxazolyl), a piperazinyl group, a piperidinyl group, a pyrazinyl group, a pyrazolyl group, a pyridazinyl group, a pyridyl group, a pyrimidinyl group, a pyrrolyl group, a pyrrolidinyl group, a tetrahydrofuranyl group, a tetrahydropyranyl group, a tetrazinyl group (including 1,2,4,5-tetrazinyl), a triazolyl group (including 1,2,3,4-triazolyl and 1,2,4,5-triazolyl), a thiadiazolyl group (including 1,2,3-thiadiazolyl, 1,2,5-thiadiazolyl, and 1,3,4-thiadiazolyl), a thiazolyl group, a thienyl group, a triazinyl group (including 1,3,5-triazinyl and 1,2,4-triazinyl), a triazolyl group (including 1,2,3-triazolyl and 1,3,4-triazolyl), etc.

The term "hydroxyl group" used in the present invention is expressed by the formula -OH.

The term "ketone" used in the present invention is expressed by the formula R¹C(O)R², wherein R¹ and R² may independently be the alkyl group, the cycloalkyl group, the alkenyl group, the cycloalkenyl group, the alkynyl group, the cycloalkynyl group, the aryl group, or the heteroaryl group described in the present invention.

The term "azido group" used in the present invention is expressed by the formula -N₃.

The term "nitro group" used in the present invention is expressed by the formula -NO₂.

The term "nitrile group" used in the present invention is expressed by the formula - CN.

The term "silyl group" used in the present invention is expressed by the formula - SiR¹R²R³, wherein R¹, R², and R³ may independently be the alkyl group, the cycloalkyl group, the alkoxy group, the alkenyl group, the cycloalkenyl group, the alkynyl group, the cycloalkynyl group, the aryl group, or the heteroaryl group described in the present invention.

The term "thio-oxo group" used in the present invention is expressed by the formula - S(O)R¹, -S(O)₂R¹, -OS(O)₂R¹ or -OS(O)₂OR¹, wherein R¹ may be the alkyl group, the cycloalkyl group, the alkenyl group, the cycloalkenyl group, the alkynyl group, the cycloalkynyl group, the aryl group, or the heteroaryl group described in the present invention. Throughout the specification, "S(O)" is an abbreviation of S=O. The term "sulfonyl group" used in the present invention refers to the thio-oxo group expressed by the formula -S(O)₂R¹, wherein R¹ may be the alkyl group, the cycloalkyl group, the alkenyl group, the cycloalkenyl group, the alkynyl group, the cycloalkynyl group, the aryl group, or the heteroaryl group. The term "sulphone" used in the present invention is expressed by the formula R¹S(O)₂R², wherein R¹ and R² may independently be the alkyl group, the cycloalkyl group, the alkenyl group, the cycloalkenyl group, the alkynyl group, the cycloalkynyl group, the aryl group, or the heteroaryl group described in the present invention. The term "sulfoxide" used in the present invention is expressed by the formula R¹S(O)R², wherein R¹ and R² may independently be the alkyl group, the cycloalkyl group, the alkenyl group, the cycloalkenyl group, the alkynyl group, the cycloalkynyl group, the aryl group, or the heteroaryl group described in the present invention.

The term "sulfhydryl group" used in the present invention is expressed by the formula -SH.

"R¹", "R²", "R³", and "Rⁿ" (wherein n is an integer) used in the present invention may independently have one or more of the groups listed above. For example, if R¹ is a linear alkyl group, a hydrogen atom of the alkyl group may be optionally substituted with the hydroxyl group, the alkoxy group, the alkyl group, the halogen, etc. Depending on the selected group, the first group may be bonded to the second group, or the first group may be side-linked (i.e. linked) to the second group. For example, for the phrase "the alkyl group including the amino group", the amino group may be bonded to a main chain of the alkyl group. Alternatively, the amino group may be linked to the main chain of the alkyl group. The nature of the selected group will determine whether the first group is embedded into or linked to the second group.

The compound of the present invention may include an "optionally substituted" moiety. In general, the term "substituted" (whether there is the term "optional" in front of it) means that one or more hydrogen in a given moiety are substituted by suitable substituents. Unless otherwise stated, the "optionally substituted" group may have suitable substituents at various substitutable positions of the group, and the substituents may be same or different at various positions when more than one positions in any given structure may be substituted by more than one substituents of the specified group. A combination of the substituents assumed in the present invention is preferably a combination to form a stable or chemically feasible compound. It can also be assumed that, in some respects, individual substituent may be further optionally substituted (i.e., further substituted or unsubstituted), unless clearly indicated to the contrary.

The structure of the compound may be expressed by the following formula:

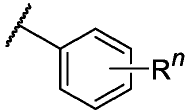

It is understood as being equivalent to the following formula: 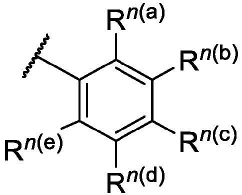 wherein n is usually an integer. That is, R*ⁿ* is understood as expressing 5 separate substituents R^{*n*(a)}, R^{*n*(b)}, R^{*n*(c)}, R^{*n*(d)}, and R^{*n*(e)}. The "separate substituent" refers to that each R substituent may be independently limited. For example, if R^{*n*(a)} is a halogen in one case, R^{*n*(b)} is not necessarily the halogen in this case.

R¹, R², R³, R⁴, R⁵, R⁶, etc. are mentioned several times in the chemical structures and units disclosed and described in the present invention. Any description of R¹, R², R³, R⁴, R⁵, R⁶, etc.in the specification is applicable to any structure or unit that cites R¹, R², R³, R⁴, R⁵, R⁶, etc., unless otherwise stated.

For a variety of reasons, an optoelectronic device using the organic material has become increasingly urgent. Many materials used for manufacturing such apparatus are relatively cheap, so an organic optoelectronic apparatus has the potential for the cost advantage of an inorganic apparatus. In addition, the organic materials are very suitable for special application such as manufacturing on a flexible substrate due to the inherent characteristics, such as flexibility. Examples of the organic optoelectronic device include an organic light-emitting device (OLED), an organic phototransistor, an organic photovoltaic cell, and an organic photodetector. For the OLED, the organic materials may have superior property advantages over conventional materials. For example, a wavelength of an organic light-emitting layer emitting light may usually be easily tuned with an appropriate dopant.

An exciton decays from a singlet excited state to a ground state, to generate instant light emission, which is fluorescence. If the exciton decays from a triplet excited state to the ground state, to generate light emission, which is phosphorescence. Due to strong spin-orbit coupling between a singlet state and the triplet excited state of heavy metal atoms, intersystem crossing (ISC) is effectively enhanced, so a phosphorescent metal complex (such as a platinum complex) has shown a potential to simultaneously utilize singlet and triplet excitons, thereby achieving 100% internal quantum efficiency. Therefore, the phosphorescent metal complex is a good candidate for a dopant in an emission layer of the organic light-emitting device (OLED), and has received great attention in academic and industrial fields. In the past decade, many achievements have been made, which leads to lucrative commercialization of this technology. For example, the OLED has been used for an advanced display of a smartphone, a televisoin, and a digital camera.

However, so far, a blue electroluminescent device is still the most challenging field in this technology, and stability of the blue device is a major problem. It has been proved that a choice of a host material is very important for the stability of the blue device. However, the lowest triplet excited state (T₁) energy of the blue luminescent material is very high, which means that the lowest triplet excited state (T₁) energy of the host material of the blue device should be higher. This leads to larger difficulty in development of the host material of blue equipment.

The metal complexes of the present invention may be customized or tuned to specific application that is expected to have specific emission or absorption characteristics. Optical properties of the metal complex in the present disclosure may be adjusted by changing a structure of a ligand around a center of the metal or a structure of a fluorescent luminophore on the ligand. For example, in emission and absorption spectra, the metal complex or an electron-withdrawing substituent of the ligand having an electron-donating substituent may usually exhibit different optical properties. A color of the metal complex may be adjusted by modifying conjugated groups on the fluorescent luminophore and the ligand.

Such emission of the complex of the present invention may be adjusted, for example, by changing the structure of the ligand or the fluorescent luminophore, for example, from ultraviolet light to near-infrared light. The fluorescent luminophore is a group of atoms in an organic molecule that may absorb energy to produce the singlet excited state, and the singlet exciton decays rapidly to generate instant light emission. In one aspect, the complex of the present invention may provide emission of most of visible spectra. In a specific example, the complex of the present invention may emit light in a range of about 400 nm to about 700 nm. In another aspect, the complex of the present invention has improved stability and efficiency compared with a traditional emission complex. Moreover, the complex of the present invention may be used as a luminescent marker for emitters in, for example, biological application, an anti-cancer agent, and an organic light-emitting diode (OLED) or a combinations thereof. In another aspect, the complex of the present invention may be used for the light-emitting device, for example, a compact fluorescent lamp (CFL), the light-emitting diode (LED), an incandescent lamp, and a combination thereof.

A platinum-contained compound or a composite complex is disclosed herein. The term compound or complex may be used interchangeably in the present invention. Moreover, the compound disclosed herein has a neutral charge.

The compound disclosed herein may exhibit desired properties, and has emission and/or absorption spectra that may be adjusted by selecting a suitable ligand. In another aspect, the present invention may exclude any one or more compounds, structures or moieties thereof specified herein.

The compound disclosed herein is suitable for a wide variety of optical and electro-optical devices, including, but not limited to, a light-absorbing device, such as solar and photosensitive devices, the organic light-emitting diode (OLED), a light-emitting device or a device that can both absorb and emit light, and a marker used for biological application.

As mentioned above, the compound disclosed is the platinum complex. Meanwhile, the compound disclosed herein may be used as the host material for OLED application, such as a full-color display.

The compound disclosed herein may be used for various application. As a luminescent material, the compound may be used for the organic light-emitting diode (OLED), the light-emitting device and display, and other light-emitting devices.

The compound of the present invention may be prepared by many methods, including, but not limited to, those described in the embodiments provided herein.

The compound disclosed herein may be a delayed fluorescent and/or phosphorescent emitter. In one aspect, the compound disclosed herein may be the delayed fluorescent emitter. In one aspect, the compound disclosed herein may be the phosphorescent emitter. In another aspect, the compound disclosed herein may be a delayed fluorescent emitter and a phosphorescent emitter.

The content of the present invention will be described below in detail. The description of the components recorded below is sometimes based on representative implementations or specific examples of the present invention, but the present invention is not limited to such implementations or specific examples.

The present disclosure relates to a cyclometalated platinum complex, which may be used as a luminescent material and a host material in the OLED.

The following embodiments provide those ordinary skilled in the art with how to manufacture and evaluate the compound described in the present invention and the OLED device thereof. The embodiments are only demonstrations of the content of the present disclosure, and do not delineate the scope of limitation. Although efforts have been made to ensure the accuracy of values (for example, quantity, temperature, etc.), some errors and deviations should be considered. Unless otherwise stated, the temperature is in °C or is an ambient temperature; and a pressure is at or near the atmospheric pressure.

The described preparation method in this embodiment for the compound disclosed by the present invention is one of many methods. There are many other methods for the preparation method for the compound disclosed by the present invention, and the present application does not delineate the scope of limitation. Therefore, those skilled in the art to which the content of the present disclosure belongs may readily modify the described method or use different methods to prepare one or more of the disclosed compounds. The following methods are only illustrative, a temperature, a catalyst, a concentration, a reactant composition, and other process conditions may be changed; and for the desired compound, those skilled in the art to which the content of the present disclosure belongs may readily select suitable reactant and conditions for preparation.

Unless otherwise stated, all commercial reagents involved in the following tests are used directly without further purification after being purchased. Botha nuclear magnetic resonance hydrogen and carbon spectra are measured in a deuterated chloroform (CDCl₃) or deuterated dimethyl sulfoxide (DMSO-d₆) solutions. The hydrogen spectrum uses a 400 or 500 MHz nuclear magnetic resonance spectrometer, and a chemical shift is based on a residual solvent. If CDCl₃ is used as the solvent, the hydrogen spectrum uses CDCl₃ (δ = 7.26 ppm) as an internal standard. If DMSO-d₆ is used as the solvent, the hydrogen spectrum uses DMSO-d₆ (δ = 2.50 ppm) as the internal standard. The following abbreviations (or combinations) are used for explaining hydrogen spectrum peaks: s = singlet, d = doublet, t = triplet, q = quartet, p = quintet, m = multiplet, br = broad.

### Embodiment 1: Synthesis of tetradentate cyclometalated platinum (II) complex Pt-17

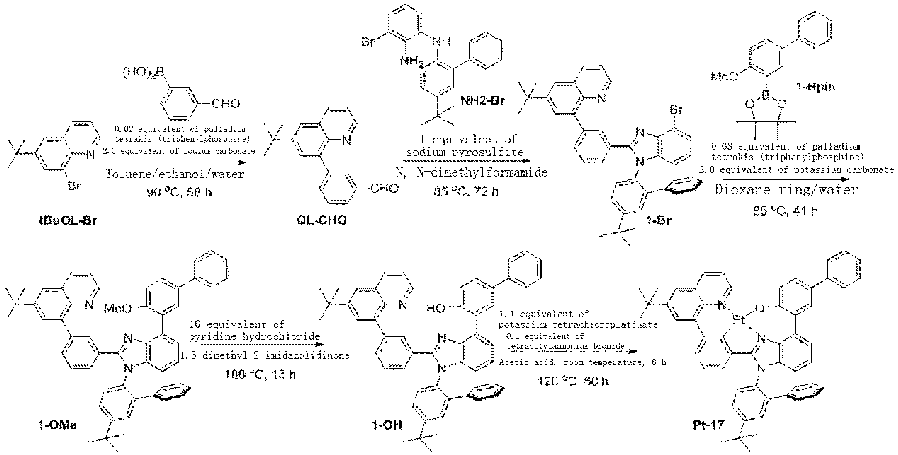

(1) Synthesis of **QL-CHO** as an intermediate: adding **tBuQL-Br** (2.0 g, 7.57 mmol, 1.0 equivalent), 3-formylphenylboronic acid (1.36 g, 9.09 mmol, 1.2 equivalent), palladium tetrakis (triphenylphosphine) (175 mg, 0.15 mmol, 2 mol%), and sodium carbonate (1.61 g, 15.14 mmol, 2.0 equivalent) to a 100 mL dry three-necked bottle with a magnetic stirrer; extracting and replacing nitrogen for three times; and adding toluene (12 mL), ethanol (10 mL), and water (5 mL) under nitrogen protection. Placing a sealed tube in an oil bath at 90°C for stirring for a reaction for 58 h; cooling the sealed tube to a room temperature; performing washing with water; and adding ethyl acetate for extraction; extracting a water layer with the ethyl acetate for three times; and performing drying with anhydrous sodium sulfate, filtering, and vacuum distillation to remove the solvent. Separating and purifying a crude product by silica gel column chromatography using an eluent (petroleum ether/ethyl acetate = (50: 1) - (10: 1)), to obtain 1.97 mg of a brown solid with a yield of 90%. ¹H NMR (500 MHz, CDCl₃) δ 1.47 (s, 9H), 7.42 (dd, *J* = 8.0, 4.0 Hz, 1H), 7.67 (t, *J =* 7.5 Hz, 1H), 7.79 (d, *J =* 2.0 Hz, 1H), 7.83 (d, *J* = 2.0 Hz, 1H), 7.94 (dt, *J =* 7.5, 1.5 Hz, 1H), 8.00 (dt, *J =* 7.5, 1.5 Hz, 1H), 8.20 (dd, *J* = 8.5, 2.0 Hz, 1H), 8.22 (t, *J* = 2.0 Hz, 1H), 8.88 (dd, *J =* 4.0, 2.0 Hz, 1H), 10.12 (s, 1H).
(2) Synthesis of **1-Br** as an intermediate: adding **QL-CHO** (314 mg, 1.08 mmol, 1.0 equivalent), **NH₂-Br** (450 mg, 1.14 mmol, 1.05 equivalent), sodium metabisulfite ( 238 mg, 1.25 mmol, 1.1 equivalent), and N, N-dimethylformamide (6 mL) to a reaction tube with a magnetic stirrer; stirring a mixture in an oil bath at 90°C for 3 days; cooled the mixture to the room temperature; diluting the mixture with the ethyl acetate; washing an organic phase with the water; and drying the organic phase with anhydrous sodium sulfate after liquid separation; performing filtration; and performing vacuum distillation on a filtrate to remove the solvent. Separating and purifying a crude product by silica gel column chromatography using an eluent (petroleum ether/ethyl acetate = (50: 1) - (10: 1), to obtain 648 mg of a white solid with a yield of 86%. ¹H NMR (500 MHz, CDCl₃) δ 1.29 (s, 9H), 1.46 (s, 9H), 6.66-6.68 (m, 2H), 6.97-7.00 (m, 2H), 7.03-7.06 (m, 1H), 7.09 (t, *J* = 8.0 Hz, 1H), 7.19 (dd, *J* = 8.0, 1.0 Hz, 1H), 7.21 (dt, *J* = 8.0, 1.5 Hz, 1H), 7.24-7.26 (m, 1H), 7.35-7.38 (m, 2H), 7.46-7.51 (m, 3H), 7.54-7.55 (m, 1H), 7.64-7.66 (m, 2H), 7.71 (d, *J =* 2.5 Hz, 1H), 8.14 (dd, *J =* 8.5, 2.0 Hz, 1H), 8.83 (dd, *J* = 4.0, 2.0 Hz, 1H).
(3) Synthesis of **1-OMe** as an intermediate: adding **1-Br** (640 mg, 0.96 mmol, 1.0 equivalent), **1-Bpin** (359 mg, 1.16 mmol, 1.2 equivalent), the palladium tetrakis (triphenylphosphine) (43 mg, 0.03 mmol, 3 mol%), and potassium carbonate (265 mg, 1.92 mmol, 2.0 equivalent) to a sealed tube with a magnetic stirrer; extracting and replacing the nitrogen for three times; and adding 1,4-dioxane ring (6 mL) and water (1 mL) under nitrogen protection. Placing a sealed tube in an oil bath at 85°C for stirring for a reaction for 41 h; cooling the sealed tube to the room temperature; performing washing with the water; and adding the ethyl acetate for extraction; extracting a water layer with the ethyl acetate for three times; and performing drying with the anhydrous sodium sulfate, filtering, and vacuum distillation to remove the solvent. Separating and purifying a crude product by silica gel column chromatography using an eluent (petroleum ether/ethyl acetate = (50: 1) - (7: 1)), to obtain 724 mg of a white solid with a yield of 98%. ¹H NMR (500 MHz, CDCl₃) δ 1.31 (s, 9H), 1.42 (s, 9H), 3.86 (s, 3H), 6.66-6.68 (m, 2H), 6.96-6.99 (m, 2H), 7.02-7.06 (m, 1H), 7.10 (d, *J =* 8.5 Hz, 1H), 7.13 (dt, *J* = 8.0, 1.5 Hz, 1H), 7.19-7.25 (m, 2H), 7.27-7.35 (m, 5H), 7.39 (d, *J =* 2.5 Hz, 1H), 7.46 (dd, *J* = 7.0, 1.5 Hz, 1H), 7.49 (t, *J* = 2.0 Hz, 1H), 7.54 (ddd, *J =* 15.0, 8.5, 2.5 Hz, 2H), 7.58-7.63 (m, 5H), 7.69 (d, *J =* 2.5 Hz, 1H), 7.92 (d, *J =* 2.5 Hz, 1H), 8.12 (dd, *J* = 8.5, 2.0 Hz, 1H), 8.80 (dd, *J =* 4.0, 2.0 Hz, 1H).
(4) Synthesis of **1-OH** as a ligand: sequentially adding **1-OMe** (700 mg, 0.91 mmol, 1.0 equivalent), pyridine hydrochloride (1.05 g, 9.11 mmol, 10 equivalent), and 1,3-dimethyl-2-imidazolinone (3 mL) to a reaction tube. Extracting and replacing the nitrogen for three times; placing the reaction tube in an oil bath at 180°C for a reaction for 13 h; cooling the reaction tube to the room temperature; performing quenching with a sodium bicarbonate solution; and adding the ethyl acetate for extraction for three times; and performing drying with the anhydrous sodium sulfate, filtering, and vacuum distillation to remove the solvent. Separating and purifying a crude product by silica gel column chromatography using an eluent (petroleum ether/ethyl acetate = (50: 1) - (5: 1)), to obtain 634 mg of a white solid with a yield of 92%. ¹H NMR (500 MHz, DMSO-*d*₆) δ 1.18 (s, 9H), 1.40 (s, 9H), 6.66-6.69 (m, 2H), 7.01-7.11 (m, 4H), 7.22-7.27 (m, 3H), 7.32-7.39 (m, 6H), 7.48 (dd, *J* = 8.5, 4.0 Hz, 1H), 7.54 (dd, *J =* 8.5, 2.5 Hz, 1H), 7.59 (dd, *J =* 8.5, 2.5 Hz, 1H), 7.61-7.65 (m, 5H), 7.70 (d, *J =* 8.5 Hz, 1H), 7.89 (d, *J* = 2.0 Hz, 1H), 7.96 (d, *J =* 2.5 Hz, 1H), 8.36 (dd, *J* = 8.5, 2.0 Hz, 1H), 8.70 (dd, *J =* 4.0, 2.0 Hz, 1H), 10.53 (s, 1H).
(5) Synthesis of **Pt-17:** sequentially adding **1-OH** ( 150 mg, 0.2 mmol, 1.0 equivalent), potassium tetrachloroplatinate (87 mg, 0.21 mmol, 1.05 equivalent), tetrabutylammonium bromide (6 mg, 0.02 mmol, 0.1 equivalent) to a 50 mL dry three-necked bottle with a magnetic rotor and a condensing tube; extracting and replacing the nitrogen for three times; adding acetic acid (15 mL); stirring a reaction liquid at the room temperature for 8 h after being bubbled with the nitrogen for 30 min, and then performing a reaction at 120°C for 60 h; and performing cooling to the room temperature, and vacuum distillation to remove the solvent. Separating and purifying a crude product by silica gel column chromatography using an eluent (petroleum ether/dichloromethane = (1: 1) - (0: 1), to obtain 117 mg of a yellow solid as a product with a yield of 62%. ¹H NMR (500 MHz, DMSO-*d*₆) δ 1.49 (s, 18H), 6.56-6.58 (m, 1H), 7.01 (d, *J =* 8.5 Hz, 1H), 7.06 (dd, *J =* 8.0, 1.0 Hz, 1H), 7.11-7.22 (m, 7H), 7.34-7.43 (m, 5H), 7.56-7.59 (m, 3H), 7.76 (d, *J =* 2.5 Hz, 1H), 7.78 (d, *J =* 8.5 Hz, 1H), 7.84 (dd, *J =* 8.5, 2.5 Hz, 1H), 8.02 (dd, *J* = 8.0, 5.5 Hz, 1H), 8.06 (d, *J* = 8.0 Hz, 1H), 8.16 (d, *J =* 2.0 Hz, 1H), 8.66 (d, *J* = 2.5 Hz, 1H), 8.96 (dd, *J* = 8.5, 2.0 Hz, 1H), 11.00 (dd, *J* = 5.5, 1.5 Hz, 1H).

### Embodiment 2: Synthesis of tetradentate cyclometalated platinum (II) complex Pt-18

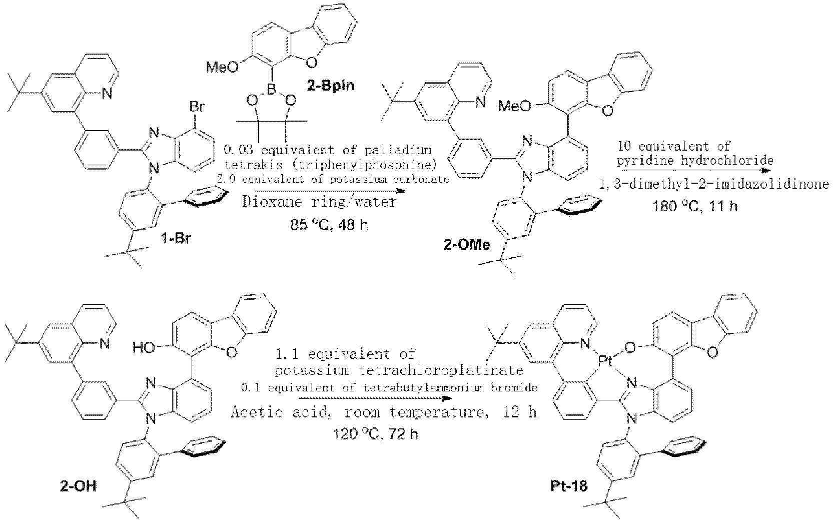

(1) Synthesis of **2-OMe** as an intermediate: adding **1-Br** (1.0 equivalent), **2-Bpin** (1.2 equivalent), palladium tetrakis (triphenylphosphine) (3 mol%), and potassium carbonate (2.0 equivalent) to a sealed tube with a magnetic stirrer; extracting and replacing the nitrogen for three times; and adding 1,4-dioxane ring (6 mL) and water (1 mL) under nitrogen protection. Placing the sealed tube in an oil bath at 85°C for stirring for a reaction for 48 h; cooling the sealed tube to a room temperature; performing washing with the water; and adding the ethyl acetate for extraction; extracting a water layer with the ethyl acetate for three times; and performing drying with anhydrous sodium sulfate, filtering, and vacuum distillation to remove the solvent. Separating and purifying a crude product by silica gel column chromatography using an eluent (petroleum ether/ethyl acetate = (50: 1) - (7: 1)), to obtain a white solid with a yield of about 90%. MS: molecular weight 781.37.
(2) Synthesis of **2-OH** as a ligand: sequentially adding **2-OMe** (1.0 equivalent), pyridine hydrochloride (10 equivalent), and 1,3-dimethyl-2-imidazolinone (5 mL) to a reaction tube. Extracting and replacing the nitrogen for three times; placing the reaction tube in an oil bath at 180°C for a reaction for 11 h; cooling the reaction tube to the room temperature; performing quenching with a sodium bicarbonate solution; and adding the ethyl acetate for extraction for three times; and performing drying with the anhydrous sodium sulfate, filtering, and vacuum distillation to remove the solvent. Separating and purifying a crude product by silica gel column chromatography using an eluent (petroleum ether/ethyl acetate = (50: 1) - (5: 1)), to obtain a white solid with a yield of about 80%. MS: molecular weight 767.35.
(3) Synthesis of **Pt-18:** sequentially adding **2-OH** (1.0 equivalent), potassium tetrachloroplatinate (1.05 equivalent), tetrabutylammonium bromide (0.1 equivalent) to a dry three-necked bottle with a magnetic rotor; extracting and replacing the nitrogen for three times; adding acetic acid (25 mL); stirring a reaction liquid at the room temperature for 12 h after being bubbled with the nitrogen for 30 min, and then performing a reaction at 120°C for 72 h; and performing cooling to the room temperature, and vacuum distillation to remove the solvent. Separating and purifying a crude product by silica gel column chromatography using an eluent (petroleum ether/dichloromethane = (1: 1) - (0: 1), to obtain a yellow solid as a product with a yield of about 50%. MS: molecular weight 960.30.

### Embodiment 3: Synthesis of tetradentate cyclometalated platinum (II) complex Pt-64

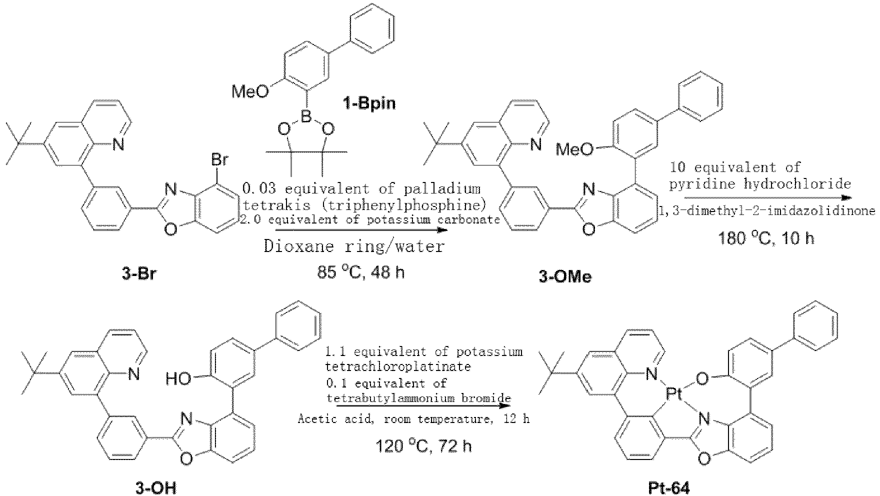

(1) Synthesis of **3-OMe** as an intermediate: adding **3-Br** (1.0 equivalent), **1-Bpin** (1.2 equivalent), palladium tetrakis (triphenylphosphine) (3 mol%), and potassium carbonate (2.0 equivalent) to a sealed tube with a magnetic stirrer; extracting and replacing the nitrogen for three times; and adding 1,4-dioxane ring (6 mL) and water (1 mL) under nitrogen protection. Placing the sealed tube in an oil bath at 85°C for stirring for a reaction for 48 h; cooling the sealed tube to a room temperature; performing washing with the water; and adding the ethyl acetate for extraction; extracting a water layer with the ethyl acetate for three times; and performing drying with anhydrous sodium sulfate, filtering, and vacuum distillation to remove the solvent. Separating and purifying a crude product by silica gel column chromatography using an eluent (petroleum ether/ethyl acetate = (50: 1) - (7: 1)), to obtain a white solid with a yield of about 85%. MS: molecular weight 560.25.
(2) Synthesis of **3-OH** as a ligand: sequentially adding **3-OMe** (1.0 equivalent), pyridine hydrochloride (10 equivalent), and 1,3-dimethyl-2-imidazolinone (6 mL) to a reaction tube. Extracting and replacing the nitrogen for three times; placing the reaction tube in an oil bath at 180°C for a reaction for 10 h; cooling the reaction tube to the room temperature; performing quenching with a sodium bicarbonate solution; and adding the ethyl acetate for extraction for three times; and performing drying with the anhydrous sodium sulfate, filtering, and vacuum distillation to remove the solvent. Separating and purifying a crude product by silica gel column chromatography using an eluent (petroleum ether/ethyl acetate = (50: 1) - (5: 1)), to obtain a white solid with a yield of about 85%. MS: molecular weight 546.23.
(3) Synthesis of **Pt-64:** sequentially adding **3-OH** (1.0 equivalent), potassium tetrachloroplatinate (1.05 equivalent), tetrabutylammonium bromide (0.1 equivalent) to a dry three-necked bottle with a magnetic rotor; extracting and replacing the nitrogen for three times; adding acetic acid (25 mL); stirring a reaction liquid at the room temperature for 12 h after being bubbled with the nitrogen for 30 min, and then performing a reaction at 120°C for 72 h; and performing cooling to the room temperature, and vacuum distillation to remove the solvent. Separating and purifying a crude product by silica gel column chromatography using an eluent (petroleum ether/dichloromethane = (1: 1) - (0: 1)), to obtain a yellow solid as a product with a yield of about 40%. MS: molecular weight 739.18.

### Embodiment 4: Synthesis of tetradentate cyclometalated platinum (II) complex Pt-104

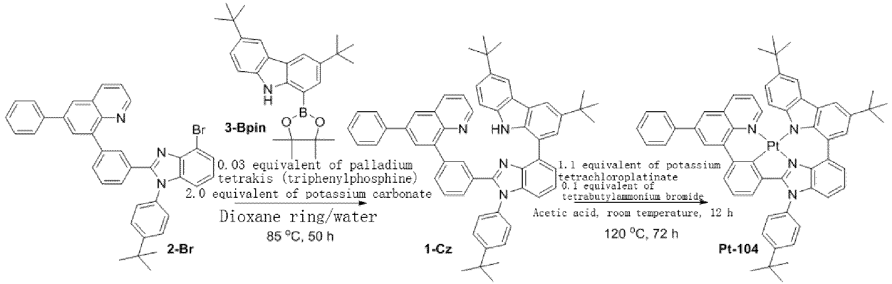

(1) Synthesis of **1-Cz** as an intermediate: adding **2-Br** (1.0 equivalent), **3-Bpin** (1.2 equivalent), palladium tetrakis (triphenylphosphine) (3 mol%), and potassium carbonate (2.0 equivalent) to a sealed tube with a magnetic stirrer; extracting and replacing the nitrogen for three times; and adding 1,4-dioxane ring (6 mL) and water (1 mL) under nitrogen protection. Placing the sealed tube in an oil bath at 85°C for stirring for a reaction for 50 h; cooling the sealed tube to a room temperature; performing washing with the water; and adding the ethyl acetate for extraction; extracting a water layer with the ethyl acetate for three times; and performing drying with anhydrous sodium sulfate, filtering, and vacuum distillation to remove the solvent. Separating and purifying a crude product by silica gel column chromatography using an eluent (petroleum ether/ethyl acetate = (50: 1) - (7: 1)), to obtain a white solid with a yield of about 90%. MS: molecular weight 806.43.
(2) Synthesis of **Pt-104:** sequentially adding **1-Cz** (1.0 equivalent), potassium tetrachloroplatinate (1.05 equivalent), tetrabutylammonium bromide (0.1 equivalent) to a dry three-necked bottle with a magnetic rotor; extracting and replacing the nitrogen for three times; adding acetic acid (25 mL); stirring a reaction liquid at the room temperature for 12 h after being bubbled with the nitrogen for 30 min, and then performing a reaction at 120°C for 72 h; and performing cooling to the room temperature, and vacuum distillation to remove the solvent. Separating and purifying a crude product by silica gel column chromatography using an eluent (petroleum ether/dichloromethane = (1: 1) - (0: 1)), to obtain a yellow solid as a product with a yield of about 30%. MS: molecular weight 999.38.

### Embodiment 5: Synthesis of tetradentate cyclometalated platinum (II) complex Pt-114

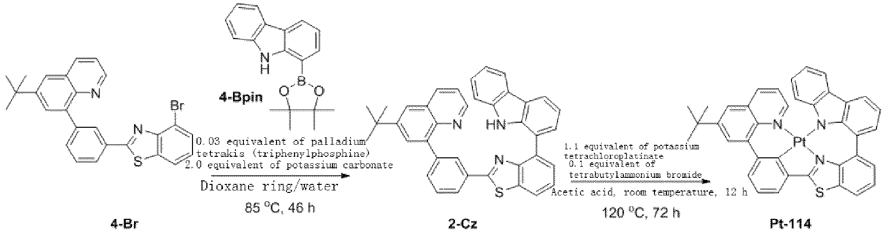

(1) Synthesis of **2-Cz** as an intermediate: adding **4-Br** (1.0 equivalent), **3-Bpin** (1.2 equivalent), palladium tetrakis (triphenylphosphine) (3 mol%), and potassium carbonate (2.0 equivalent) to a sealed tube with a magnetic stirrer; extracting and replacing the nitrogen for three times; and adding 1,4-dioxane ring (6 mL) and water (1 mL) under nitrogen protection. Placing the sealed tube in an oil bath at 85°C for stirring for a reaction for 41 h; cooling the sealed tube to a room temperature; performing washing with the water; and adding the ethyl acetate for extraction; extracting a water layer with the ethyl acetate for three times; and performing drying with anhydrous sodium sulfate, filtering, and vacuum distillation to remove the solvent. Separating and purifying a crude product by silica gel column chromatography using an eluent (petroleum ether/ethyl acetate = (50: 1) - (5: 1)), to obtain a white solid with a yield of about 80%. MS: molecular weight 559.21.
(3) Synthesis of **Pt-114:** sequentially adding **2-Cz** (1.0 equivalent), potassium tetrachloroplatinate (1.05 equivalent), tetrabutylammonium bromide (0.1 equivalent) to a dry three-necked bottle with a magnetic rotor; extracting and replacing the nitrogen for three times; adding acetic acid (25 mL); stirring a reaction liquid at the room temperature for 12 h after being bubbled with the nitrogen for 30 min, and then performing a reaction at 120°C for 72 h; and performing cooling to the room temperature, and vacuum distillation to remove the solvent. Separating and purifying a crude product by silica gel column chromatography using an eluent (petroleum ether/dichloromethane = (1: 1) - (0: 1)), to obtain a yellow solid as a product with a yield of about 20%. MS: molecular weight 752.16.

### Embodiment 6: Synthesis of tetradentate cyclometalated platinum (II) complex Pt-113

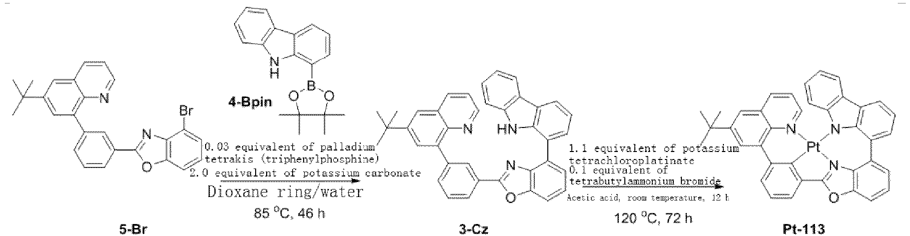

(1) Synthesis of **3-Cz** as an intermediate: adding **5-Br** (1.0 equivalent), **4-Bpin** (1.2 equivalent), palladium tetrakis (triphenylphosphine) (3 mol%), and potassium carbonate (2.0 equivalent) to a sealed tube with a magnetic stirrer; extracting and replacing the nitrogen for three times; and adding 1,4-dioxane ring (6 mL) and water (1 mL) under nitrogen protection. Placing the sealed tube in an oil bath at 85°C for stirring for a reaction for 41 h; cooling the sealed tube to a room temperature; performing washing with the water; and adding the ethyl acetate for extraction; extracting a water layer with the ethyl acetate for three times; and performing drying with anhydrous sodium sulfate, filtering, and vacuum distillation to remove the solvent. Separating and purifying a crude product by silica gel column chromatography using an eluent (petroleum ether/ethyl acetate = (50: 1) - (5: 1)), to obtain a white solid with a yield of about 85%. MS: molecular weight 543.23.
(3) Synthesis of **Pt-113:** sequentially adding **3-Cz** (1.0 equivalent), potassium tetrachloroplatinate (1.05 equivalent), tetrabutylammonium bromide (0.1 equivalent) to a dry three-necked bottle with a magnetic rotor; extracting and replacing the nitrogen for three times; adding acetic acid (25 mL); stirring a reaction liquid at the room temperature for 12 h after being bubbled with the nitrogen for 30 min, and then performing a reaction at 120°C for 72 h; and performing cooling to the room temperature, and vacuum distillation to remove the solvent. Separating and purifying a crude product by silica gel column chromatography using an eluent (petroleum ether/dichloromethane = (1: 1) - (0: 1)), to obtain a yellow solid as a product with a yield of about 30%. MS: molecular weight 736.18.

### Embodiment 7: Synthesis of tetradentate cyclometalated platinum (II) complex Pt-134

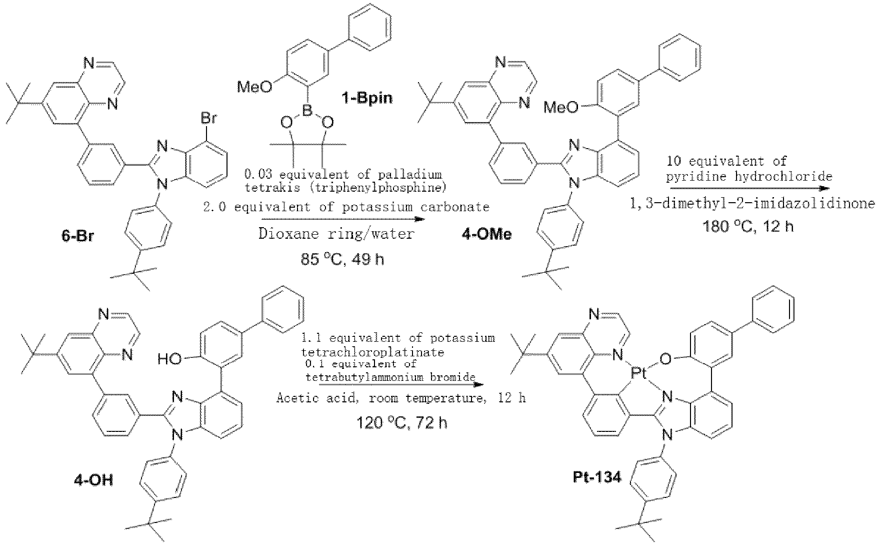

(1) Synthesis of **4-OMe** as an intermediate: adding **6-Br** (1.0 equivalent), **1-Bpin** (1.2 equivalent), palladium tetrakis (triphenylphosphine) (3 mol%), and potassium carbonate (2.0 equivalent) to a sealed tube with a magnetic stirrer; extracting and replacing the nitrogen for three times; and adding 1,4-dioxane ring (6 mL) and water (1 mL) under nitrogen protection. Placing the sealed tube in an oil bath at 85°C for stirring for a reaction for 49 h; cooling the sealed tube to a room temperature; performing washing with the water; and adding the ethyl acetate for extraction; extracting a water layer with the ethyl acetate for three times; and performing drying with anhydrous sodium sulfate, filtering, and vacuum distillation to remove the solvent. Separating and purifying a crude product by silica gel column chromatography using an eluent (petroleum ether/ethyl acetate = (50: 1) - (7: 1)), to obtain a white solid with a yield of about 75%. MS: molecular weight 692.35.
(2) Synthesis of **4-OH** as a ligand: sequentially adding **4-OMe** (1.0 equivalent), pyridine hydrochloride (10 equivalent), and 1,3-dimethyl-2-imidazolinone (3 mL) to a reaction tube. Extracting and replacing the nitrogen for three times; placing the reaction tube in an oil bath at 180°C for a reaction for 12 h; cooling the reaction tube to the room temperature; performing quenching with a sodium bicarbonate solution; and adding the ethyl acetate for extraction for three times; and performing drying with the anhydrous sodium sulfate, filtering, and vacuum distillation to remove the solvent. Separating and purifying a crude product by silica gel column chromatography using an eluent (petroleum ether/ethyl acetate = (50: 1) - (5: 1)), to obtain a white solid with a yield of about 80%. MS: molecular weight 678.34.
(3) Synthesis of **Pt-134:** sequentially adding **4-OH** (1.0 equivalent), potassium tetrachloroplatinate (1.05 equivalent), tetrabutylammonium bromide (0.1 equivalent) to a dry three-necked bottle with a magnetic rotor; extracting and replacing the nitrogen for three times; adding acetic acid (20 mL); stirring a reaction liquid at the room temperature for 12 h after being bubbled with the nitrogen for 30 min, and then performing a reaction at 120°C for 72 h; and performing cooling to the room temperature, and vacuum distillation to remove the solvent. Separating and purifying a crude product by silica gel column chromatography using an eluent (petroleum ether/dichloromethane = (1: 1) - (0: 1)), to obtain a yellow solid as a product with a yield of about 20%. MS: molecular weight 871.29.

### Descriptions of Photophysical tests and theoretical calculation:

A steady-state emission experiment and service life measurement are performed using a Horiba Jobin Yvon FluoroLog-3 spectrometer. Pt (II) complexes are subjected to theoretical calculation by a Titan software package. A geometric structure of a ground state (S₀) molecule is optimized by a density functional theory (DFT). DFT calculation is performed using B3LYP functional, wherein C, H, O, S and N atoms use a 6-31G (d) basis set, and a Pt atom uses a LANL2DZ basis set.

### Experiment data and analysis

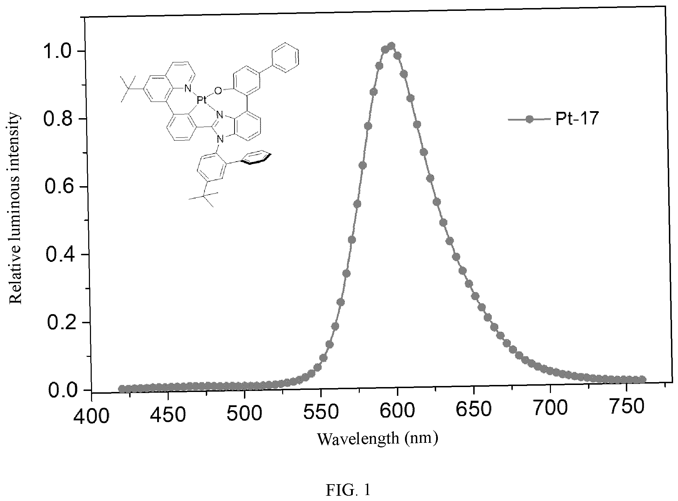

It can be seen from FIG. 1 that Pt-17 may emit strong orange-red light; the quantum efficiency of a polymethyl methacrylate (PMMA) film of the Pt-17 is larger than 80%, and the polymethyl methacrylate (PMMA) film may be reused as a light-emitting layer material of an OLED.

The density functional theory (DFT) is used to calculate the following structures:

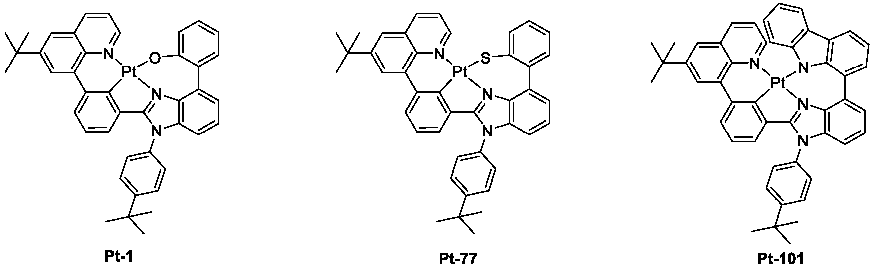

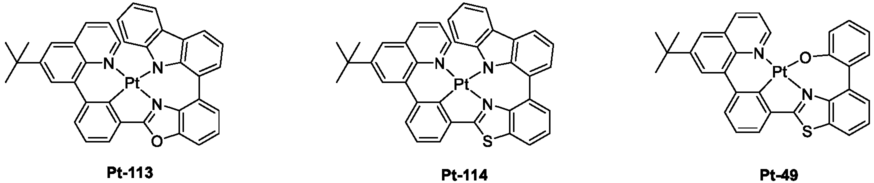

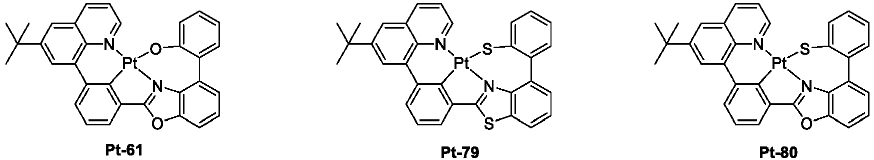

**Table 1. Theoretical Calculation Data of DFT**

| **Nam e** | **LUMO/e V** | **HOMO/e V** | **Bandgap/e V** | **Nam e** | **LUMO/e V** | **HOMO/e V** | **Bandgap/e V** |
|---|---|---|---|---|---|---|---|
| Pt-1 | -1.93 | -4.46 | **2.53** | Pt-49 | -2.12 | -4.73 | **2.61** |
| Pt-77 | -1.92 | -4.47 | **2.55** | Pt-61 | -2.15 | -4.70 | **2.55** |
| Pt-101 | -2.03 | -4.14 | **2.11** | Pt-79 | -2.11 | -4.73 | **2.62** |
| Pt-113 | -2.22 | -4.40 | **2.18** | Pt-80 | -2.11 | -4.75 | **2.64** |
| Pt-114 | -2.23 | -4.36 | **2.13** | | | | |

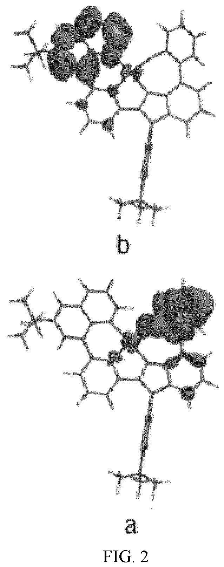

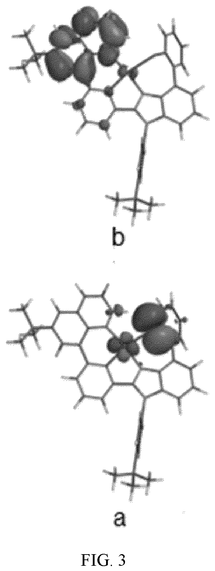

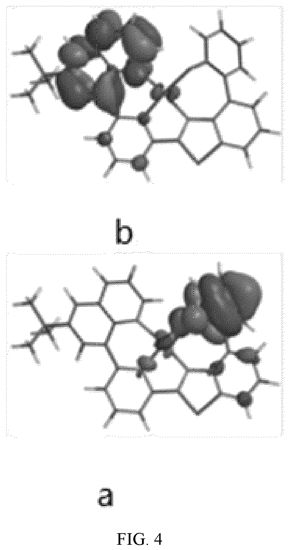

According to results of density functional theory (DFT) calculation (Table 1, FIG.2, FIG.3, and FIG. 4), Pt-1, Pt-77, Pt-49, Pt-61, Pt-79, Pt-80, Pt-101, Pt-113 and Pt-114 have almost the same LUMO orbital distribution. The LUMO orbital distribution mainly focuses on quinoline, and different electron-donating groups have little effect on LUMO orbital distribution. However, energy level distribution will change with changes of an electron-donating moiety and a fused ring, so as to adjust a luminescence color and the quantum efficiency. In general, the results of density functional theory (DFT) calculation show that the photophysical properties of a luminescent material can be efficiently controlled by adjusting structures of the electron-donating moiety and the fused ring on the ligand of the material. The above experimental data and theoretical calculation results fully show that the tetradentate cyclometalated platinum complex phosphor material based on a 8-phenylquinoline derivative developed in the application of the present invention has the characteristics of easy adjustment on HOMO and LUMO orbital energy levels, short excited state life, and high phosphorescence quantum efficiency, which indicates that the tetradentate cyclometalated platinum complex has a great application prospect in the field of the OLEDs.

### Device Embodiment

Each layer of the organic light-emitting device of the present invention may be formed by vacuum evaporation, sputtering, ion plating, or wet film forming methods such as spin coating, printing, etc.; and the solvent used is not particularly limited.

In a preferred implementation of the present invention, the OLED of the present invention includes a hole transporting layer, and a hole transporting material may be preferably selected from known or unknown materials, especially preferably selected from the following structures, which does not mean that the present invention is limited to the following structures:

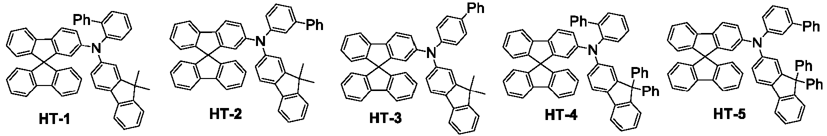

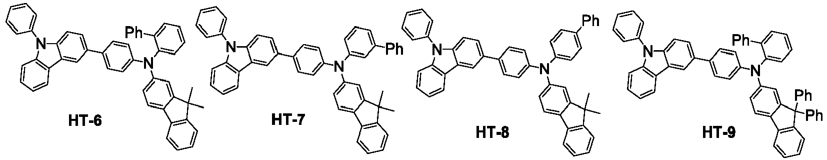

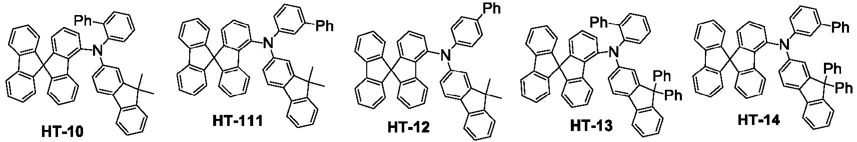

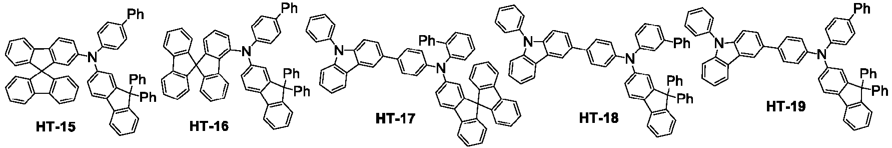

In a preferred implementation of the present invention, the OLED of the present invention includes the hole transporting layer which includes one or more p-type dopants. Preferred p-type dopants of the present invention have the following structures, which does not mean that the present invention is limited to the following structures:

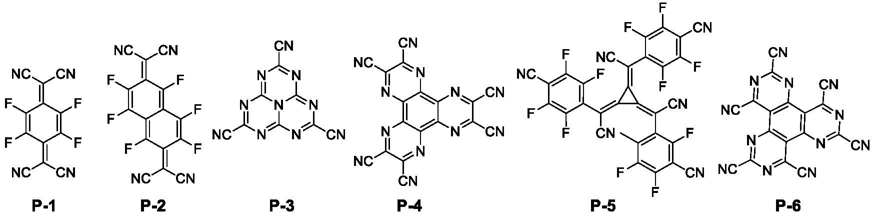

In a preferred implementation of the present invention, an electron transporting layer may be selected from at least one of compounds ET-1 to ET-13, which does not mean that the present invention is limited to the following structures:

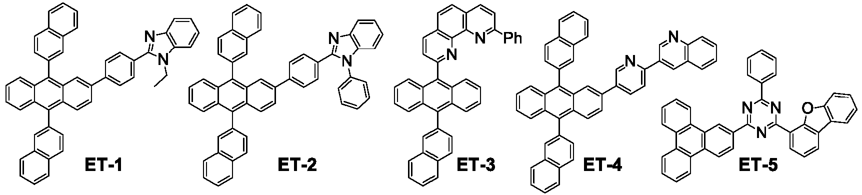

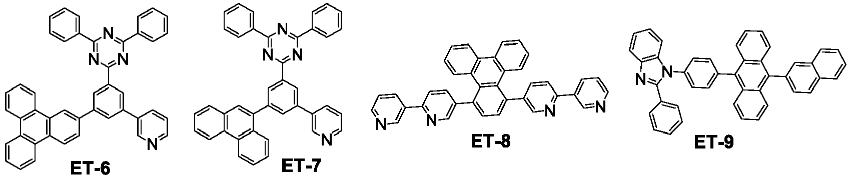

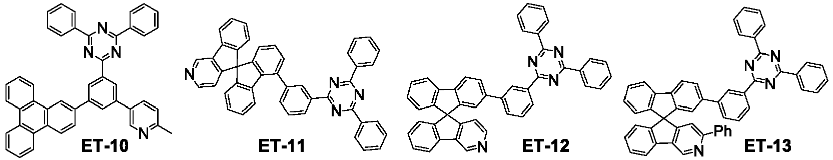

The electron transporting layer may be jointly formed by the organic material and one or more n-type dopants (such as LiQ).

### OLED Embodiment:

A structure of specifically implementing a bottom-emitting OLED is as follows: on glass including ITO, there are a hole injection layer (HIL) with HT-1: P-3 (95 : 5 v/v %) with a thickness of 10 nm; the hole transporting layer (HTL) being HT-1 with a thickness of 90 nm; an electron blocking layer (EBL) being HT-10 with a thickness of 10 nm; a light-emitting layer (EML) with the host material (RH): the platinum metal complex (95 : 5 v/v %) of the present invention, with a thickness of 35 nm; the electron transporting layer (ETL) being ET-13 LiQ (50: 50 v/v %), with a thickness of 35 nm; and then an evaporated cathode Al of 70 nm. The host material (RH) may be selected from the following structures:

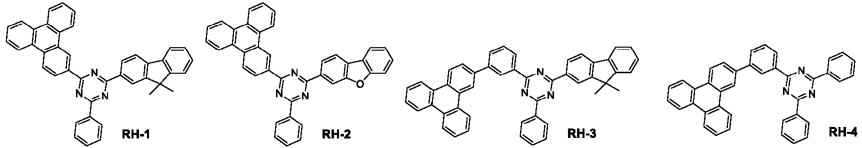

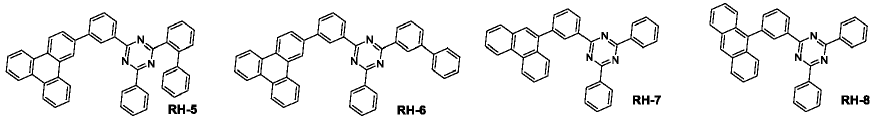

A voltage, the efficiency and the service life of the organic light-emitting device are tested under a current of 10 mA/cm² using a standard method known in the art.

The property test results of the organic light-emitting device prepared in the embodiments of the present invention and comparative examples are shown in Table 3.

**Table 3**

| Device | Platinum metal complex in light-emitting layer | Voltage (V) (Relative value, %) | Efficiency (cd/A) (Relative value, %) | LT₉₅ (hr) (Relative value, %) |
|---|---|---|---|---|
| Device 1 | Pt-17 | 75 | 157 | 198 |
| Device 2 | Pt-18 | 74 | 172 | 178 |
| Device 3 | Pt-64 | 77 | 172 | 295 |
| Device 4 | Pt-104 | 72 | 171 | 225 |
| Device 5 | Pt-114 | 73 | 156 | 289 |
| Device 6 | Pt-113 | 74 | 161 | 294 |
| Device 7 | Pt-134 | 71 | 175 | 296 |
| Comparative device | 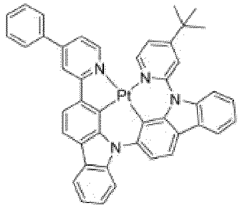 | 100 | 100 | 100 |

It can be seen from Table 3 that the device structures in the above embodiments and the comparative examples are consistent except for different light-emitting layers. Based on the device properties of PtON11Me as a reference, the current efficiency of the device including a divalent platinum metal complex of the present invention is significantly improved, and the service life is also prolonged at the same time, compared with a conventional organic light-emitting device. In summary, a novel divalent platinum metal complex in the present invention has a great application value in the organic optoelectronic device.

Those ordinary skilled in the art can understand that the above implementations are specific embodiments of the present invention, while in practical applications, they can make various changes in form and detail without deviating from the spirit and scope of the present invention. For example, without deviating from the spirit of the present invention, structures of many substituents described here can be substituted with other structures.

## Claims

1. A metal platinum complex, wherein the metal platinum complex has a structure shown as a general formula (1): 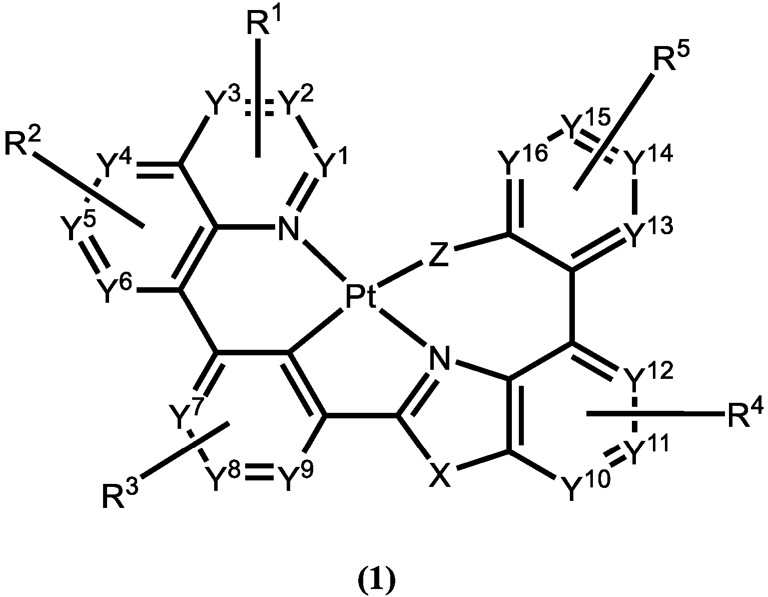 wherein
Y¹, Y², Y³, Y⁴, Y⁵, Y⁶, Y⁷, Y⁸, Y⁹, Y¹⁰, Y¹¹, Y¹², Y¹³, Y¹⁴, Y¹⁵ and Y¹⁶ are each independently CH or N;
R¹, R², R³, R⁴ and R⁵ each independently represent mono-substitution, di-substitution, tri-substitution, tetra-substitution or non-substitution, and are each independently selected from hydrogen, deuterium, an aryl group, a cycloalkyl group, a cycloalkenyl group, a heterocyclic group, a heteroaryl group, an alkyl group, an alkenyl group, an alkynyl group, halogen, a hydroxyl group, a sulfhydryl group, a nitro group, a cyano group, an amino group, a mono- or di-alkylamino group, a mono- or di-arylamino group, an alkoxy group, an aryloxy group, a haloalkyl group, an ester group, a nitrile group, an isonitrile group, a heteroaryl group, an alkoxycarbonyl group, an amido group, an alkoxycarbonylamino group, an aryloxycarbonylamino group, a sulfonylamino group, a sulfamoyl group, a carbamoyl group, an alkylthio group, a sulfinyl group, a ureido group, a phosphoramide group, an imino group, a sulfo group, a carboxyl group, a hydrazino group, a substituted silyl group, a polymerized groups, or a combination thereof; and two or more adjacent R¹, R², R³, R⁴ and R⁵ are each linked independently or selectively to form a fused ring;
X represents NR^{a}, O, and S, wherein R^{a} represents the hydrogen, the deuterium, the aryl group, the cycloalkyl group, the cycloalkenyl group, the heterocyclic group, the heteroaryl group, the alkyl group, the alkenyl group, the alkynyl group, the halogen, the hydroxyl group, the sulfhydryl group, the alkoxy group, the aryloxy group, the haloalkyl group, the ester group, the nitrile group, the isonitrile group, the heteroaryl group, the alkoxycarbonyl group, the amido group, the alkoxycarbonylamino group, the aryloxycarbonylamino group, the sulfonylamino group, the sulfamoyl group, the carbamoyl group, the alkylthio group, the sulfinyl group, the ureido group, the phosphoramide group, the imino group, the sulfo group, the carboxyl group, the hydrazino group, the substituted silyl group, the polymerized groups, or a combination thereof, and may be linked to adjacent R³ and R⁴ each independently or selectively to form a fused ring;
Z represents O, S, and NR^{b}, wherein R^{b} represents the hydrogen, the deuterium, the aryl group, the cycloalkyl group, the cycloalkenyl group, the heterocyclic group, the heteroaryl group, the alkyl group, the alkenyl group, the alkynyl group, the halogen, the hydroxyl group, the sulfhydryl group, the alkoxy group, the aryloxy group, the haloalkyl group, the ester group, the nitrile group, the isonitrile group, the heteroaryl group, the alkoxycarbonyl group, the amido group, the alkoxycarbonylamino group, the aryloxycarbonylamino group, the sulfonylamino group, the sulfamoyl group, the carbamoyl group, the alkylthio group, the sulfinyl group, the ureido group, the phosphoramide group, the imino group, the sulfo group, the carboxyl group, the hydrazino group, the substituted silyl group, the polymerized groups, or a combination thereof, and may be linked to adjacent R¹ and R⁵ each independently or selectively to form a fused ring.

2. The metal platinum complex according to claim 1, wherein the metal platinum complex is any one of the following structure:

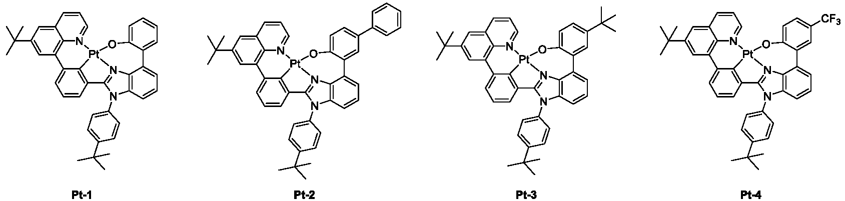

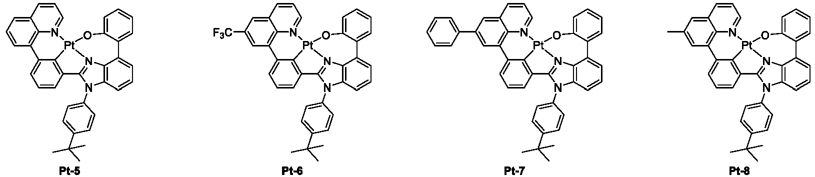

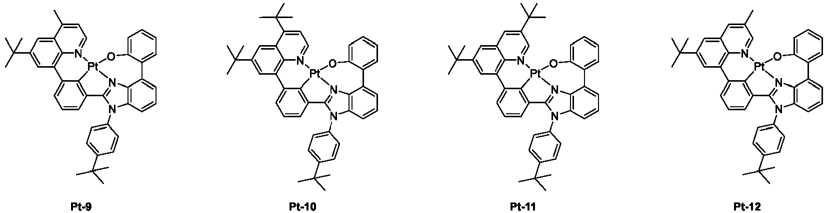

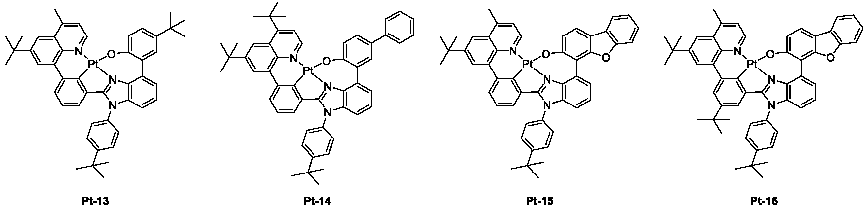

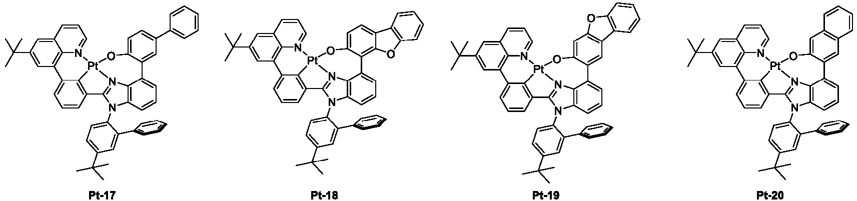

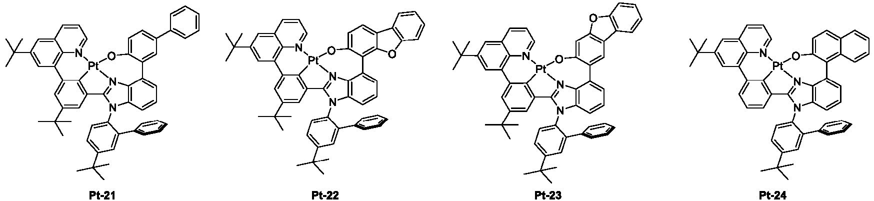

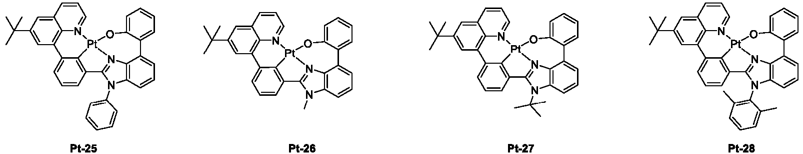

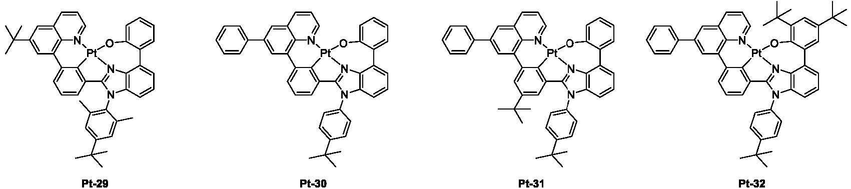

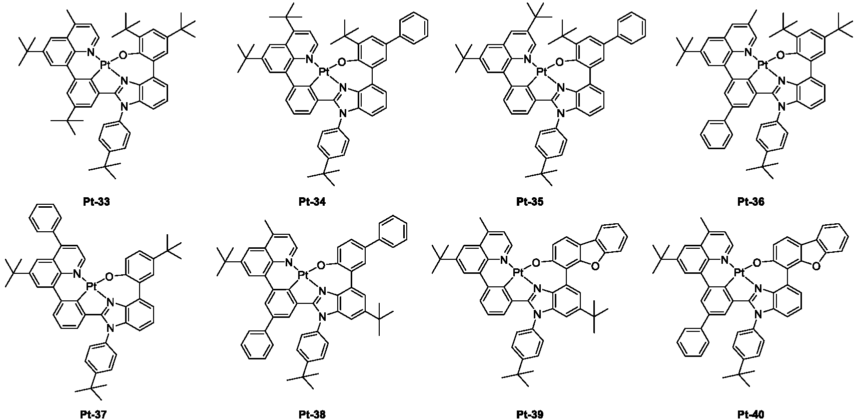

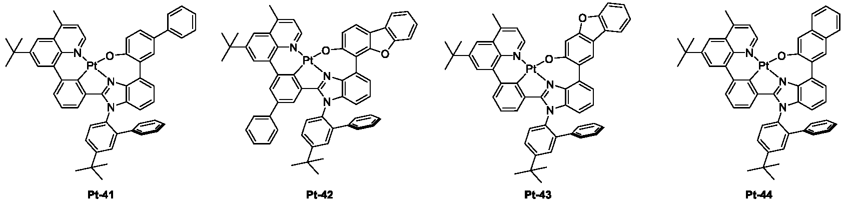

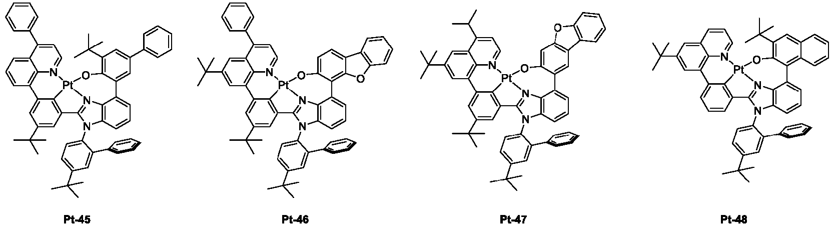

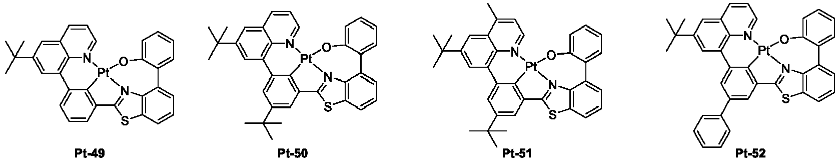

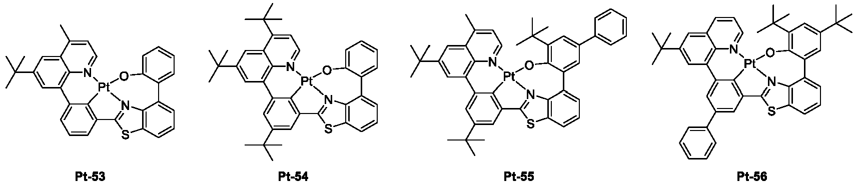

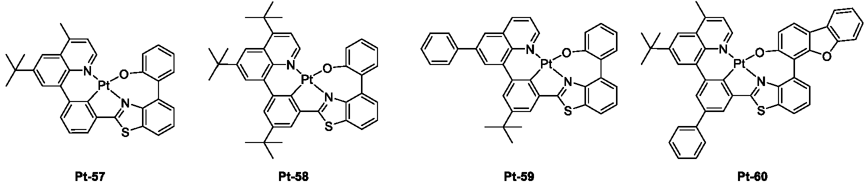

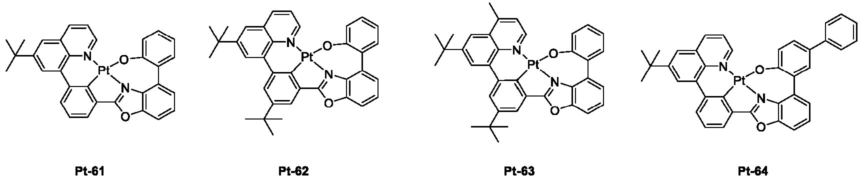

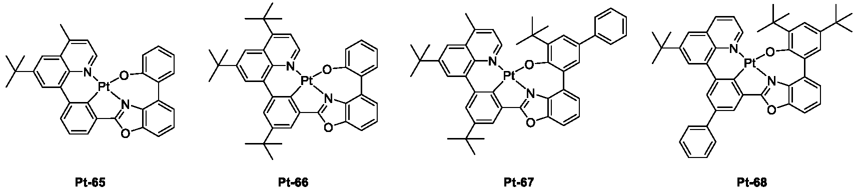

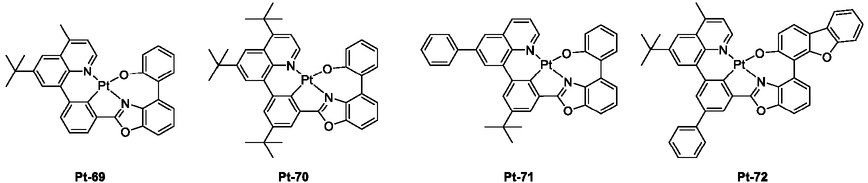

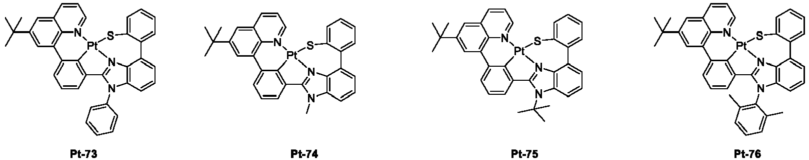

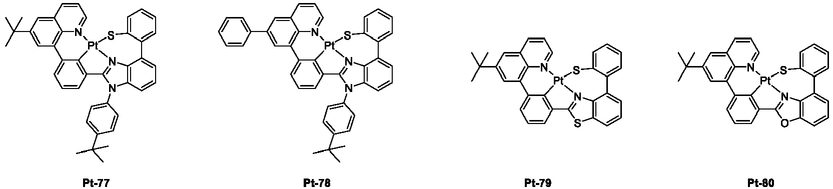

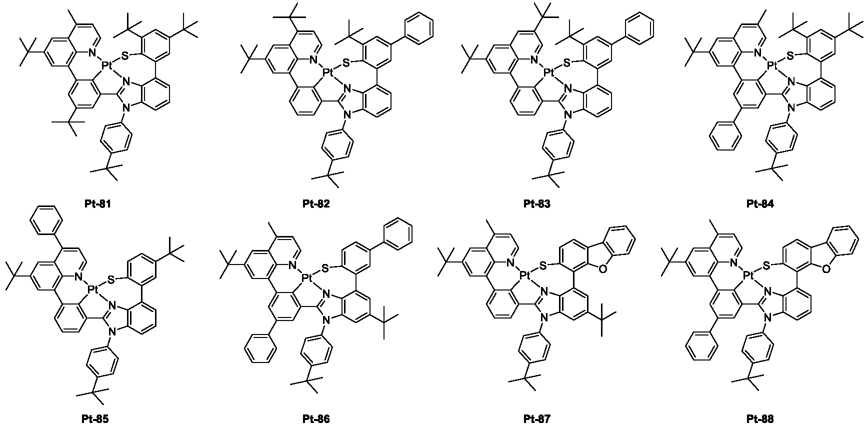

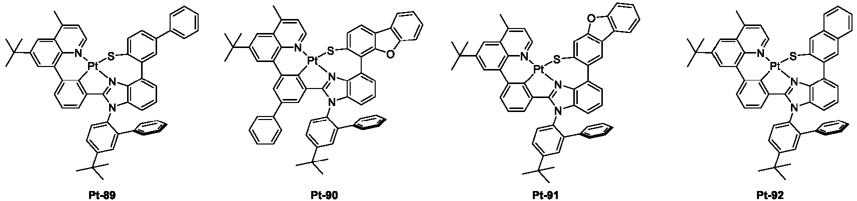

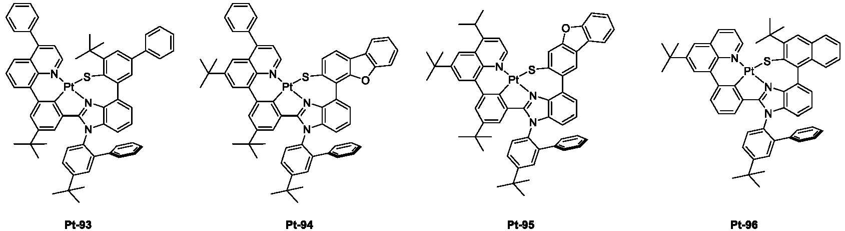

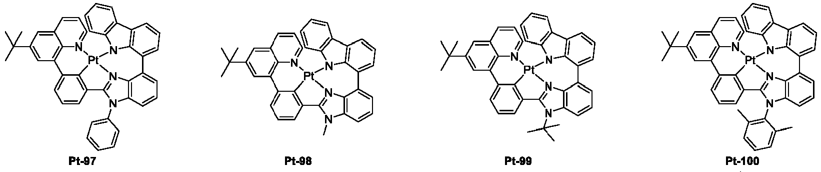

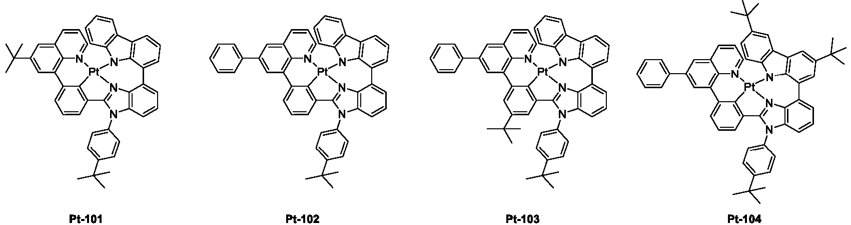

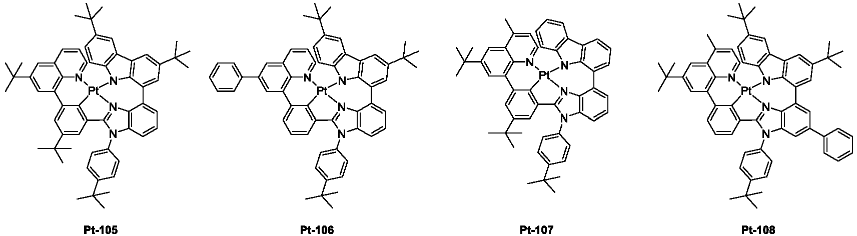

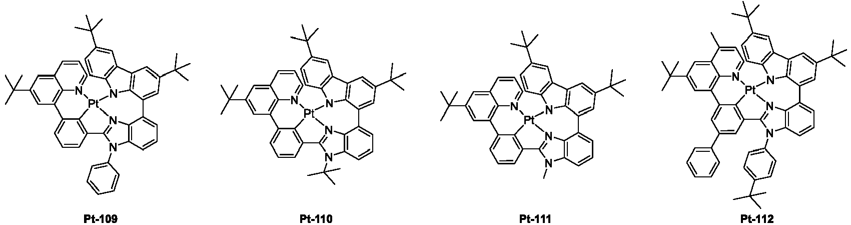

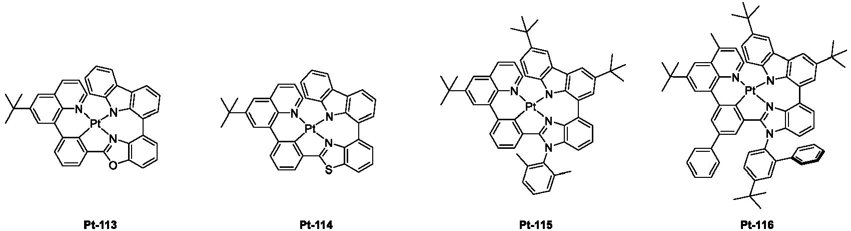

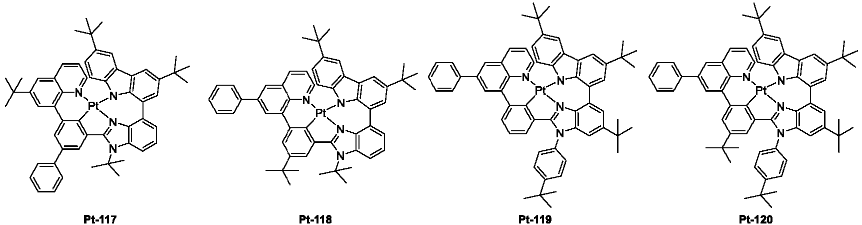

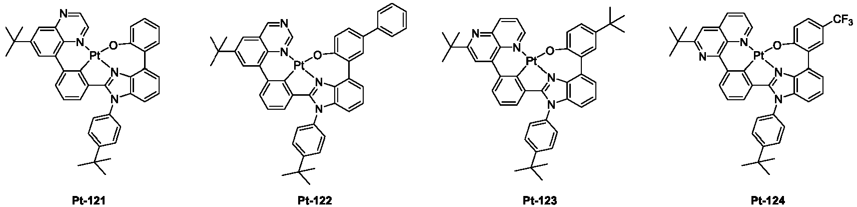

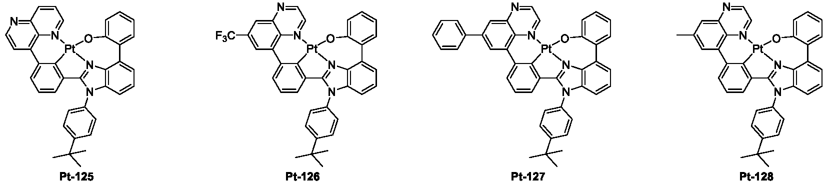

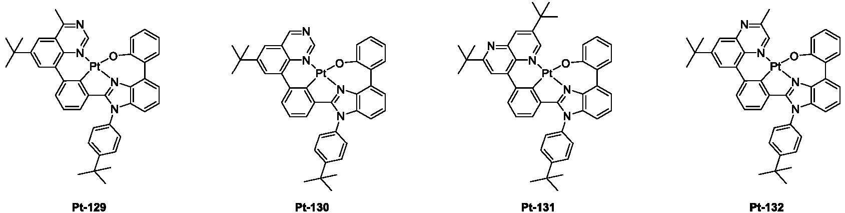

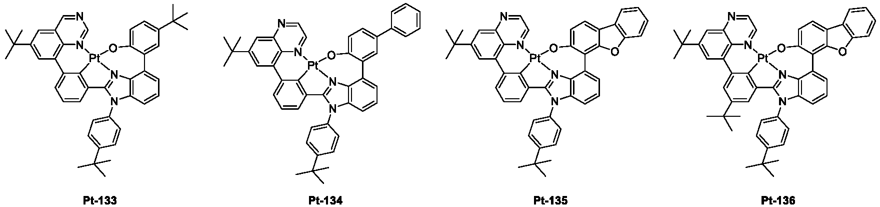

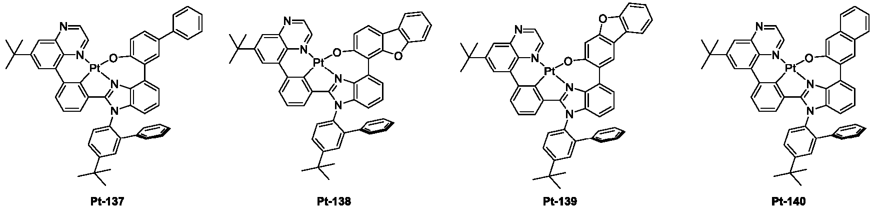

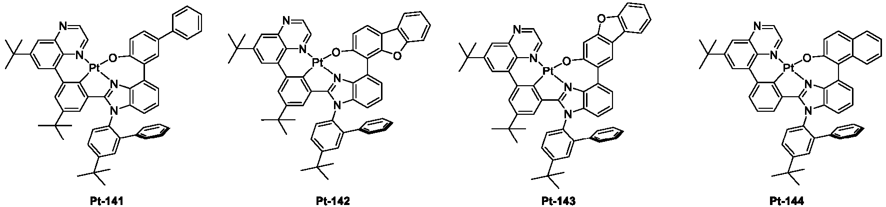

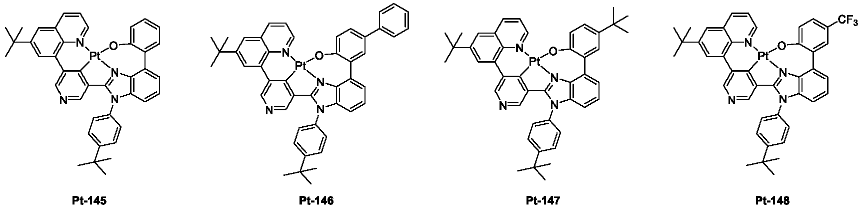

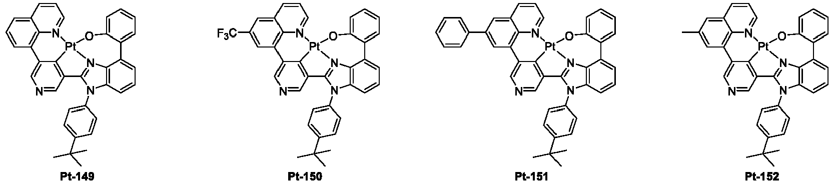

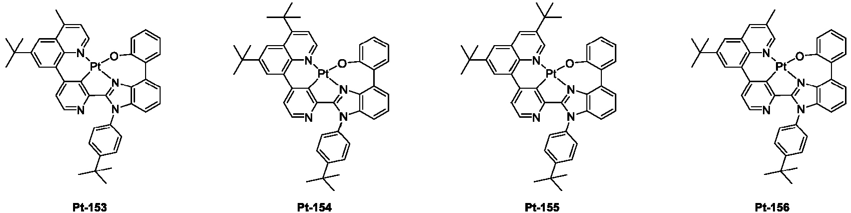

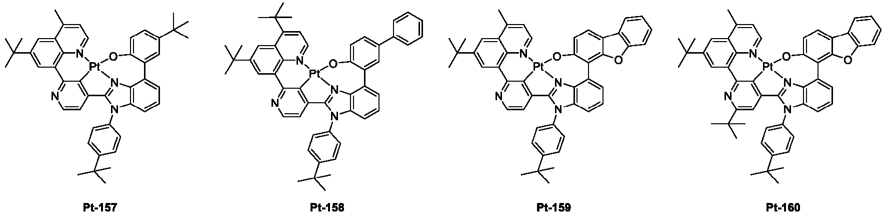

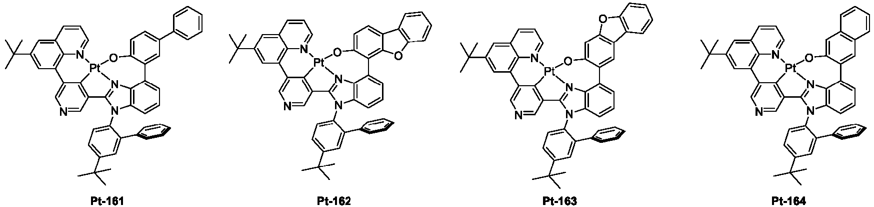

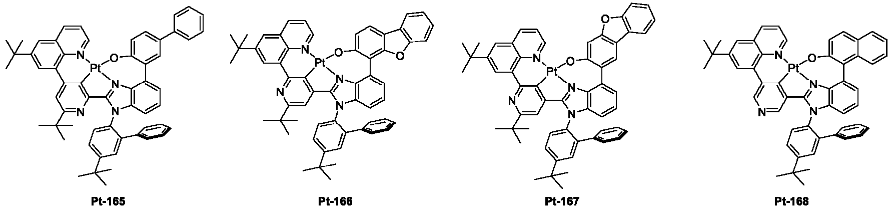

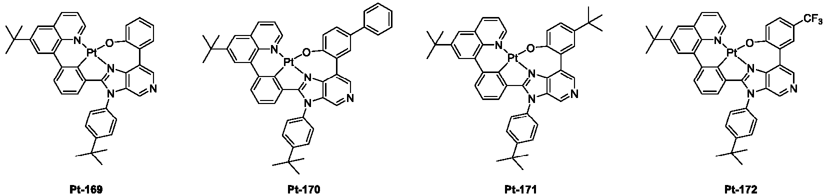

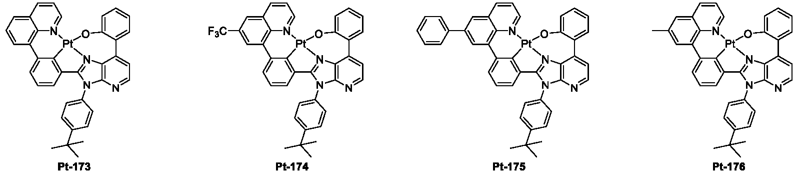

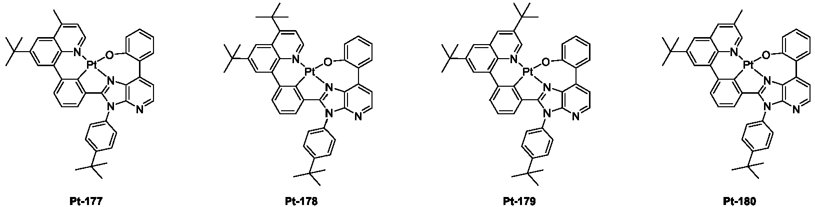

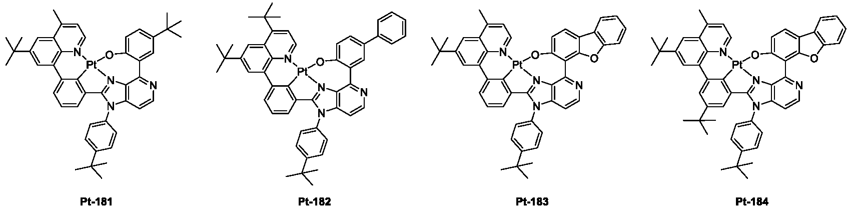

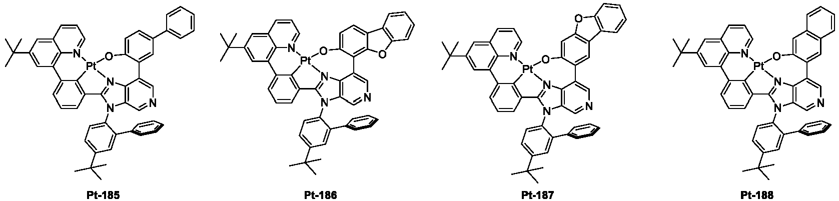

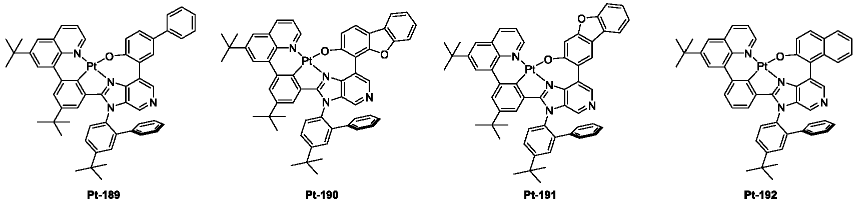

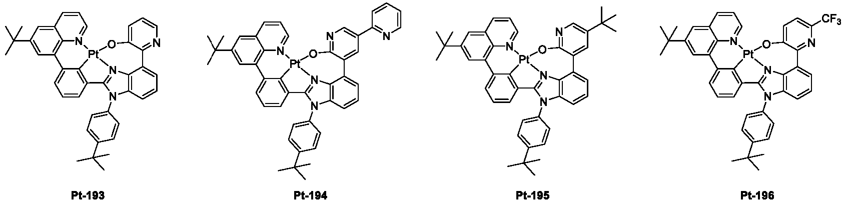

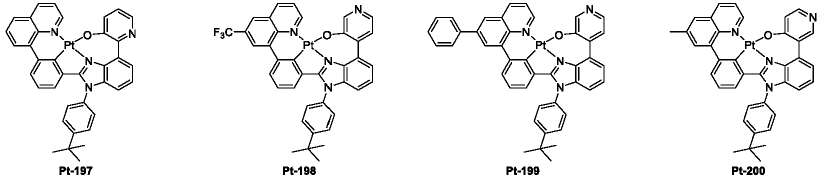

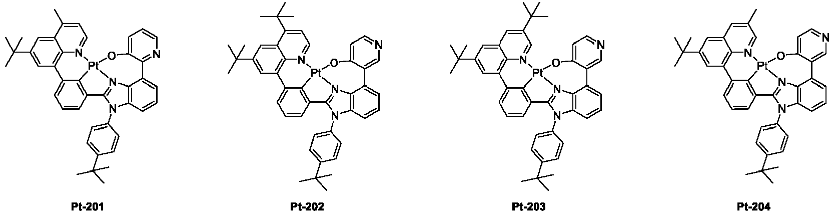

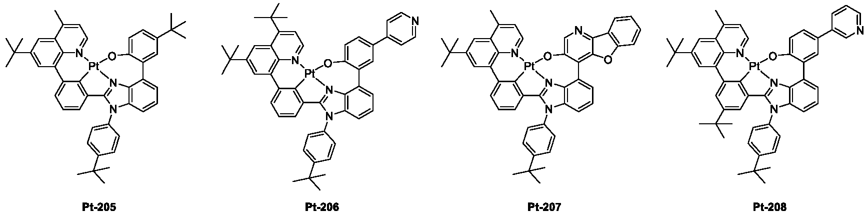

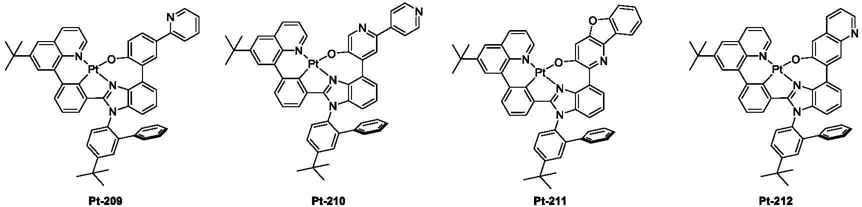

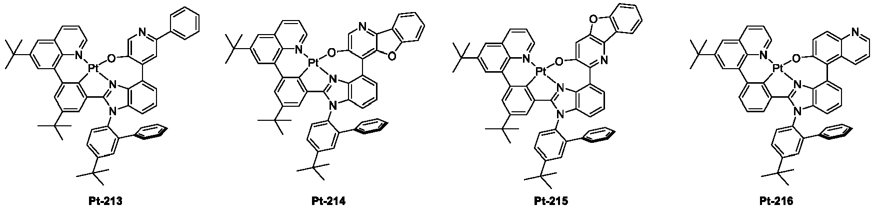

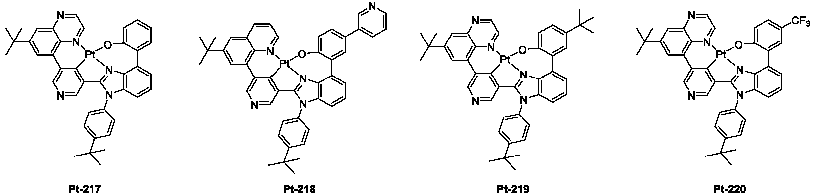

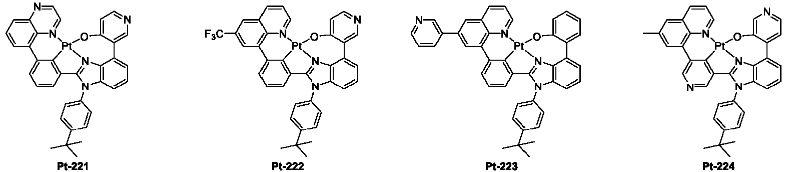

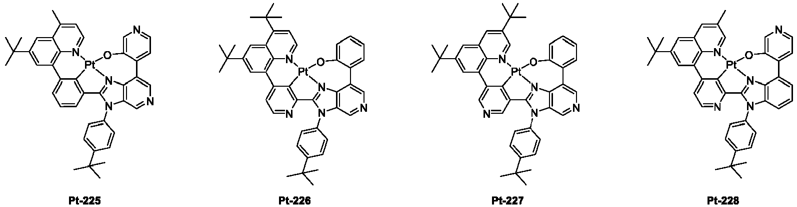

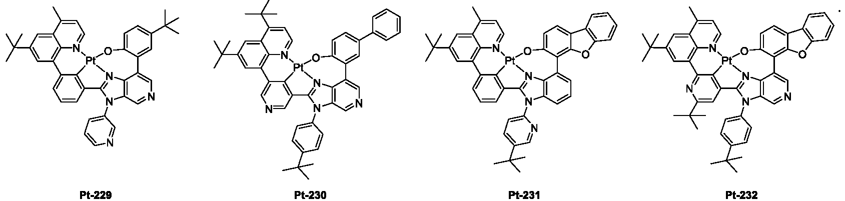

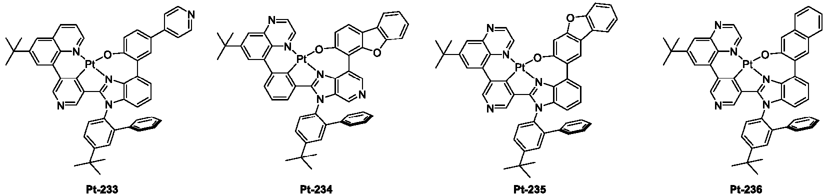

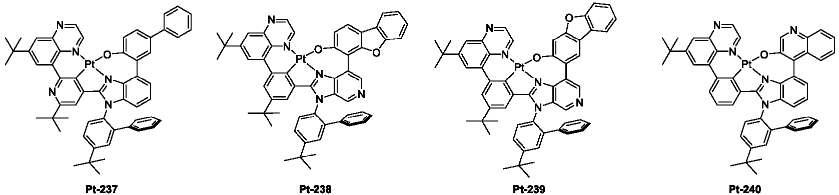

3. An organic light-emitting device, wherein the organic light-emitting device is provided with a light-emitting layer comprising the metal platinum complex according to claim 1 or 2 on a substrate.

4. A device, comprising the metal platinum complex according to claim 1 or 2.

5. The device according to claim 4, wherein the device is a full-color display, a photovoltaic device, a light-emitting display device, or an organic light-emitting diode.

6. The device according to claim 5, comprising at least one cathode, at least one anode, and at least one light-emitting layer, wherein at least one of the light-emitting layers comprises the metal platinum complex according to claim 1 or 2.

7. The device according to claim 6, wherein the device is the organic light-emitting diode, wherein the light-emitting layer of the device comprises the metal platinum complex and a corresponding host material, wherein a mass percentage of the metal platinum complex is 1%-50%, and there is no limitation to the host material.

8. A display or lighting apparatus, comprising the device according to claims 4-7.

9. An application of the metal platinum complex according to any one of claims 1-2 in manufacturing an organic optoelectronic device.
